(19) Europäisches Patentamt
European Patent Office
Office européen des brevets

(11) **EP 2 958 072 A1**

(12) **EUROPEAN PATENT APPLICATION**
published in accordance with Art. 153(4) EPC

(43) Date of publication:
**23.12.2015 Bulletin 2015/52**

(51) Int Cl.:
**G06Q 50/10** *(2012.01)*    **G06Q 50/06** *(2012.01)*

(21) Application number: **14751494.7**

(86) International application number:
**PCT/JP2014/053278**

(22) Date of filing: **13.02.2014**

(87) International publication number:
**WO 2014/126131 (21.08.2014 Gazette 2014/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **13.02.2013 JP 2013025732**

(71) Applicants:
• **Kozo Keikaku Engineering Inc.**
**Tokyo 164-0012 (JP)**
• **Nitto Denko Corporation**
**Ibaraki-shi, Osaka 567-8680 (JP)**

(72) Inventors:
• **MATSUYAMA Takashi**
**Kyoto-shi**
**Kyoto 606-8501 (JP)**

• **KATO Takekazu**
**Kyoto-shi**
**Kyoto 606-8501 (JP)**
• **YAMADA Yusuke**
**Kyoto-shi**
**Kyoto 606-8501 (JP)**
• **SHIMURA Taichi**
**Tokyo 164-0012 (JP)**
• **TAUCHI Maito**
**Tokyo 164-0012 (JP)**

(74) Representative: **Grosse, Felix Christopher**
**Grosse - Schumacher - Knauer - von Hirschhausen**
**Patent- und Rechtsanwälte**
**Nymphenburger Straße 14**
**80335 München (DE)**

(54) **LIFESTYLE BEHAVIOR ESTIMATION SYSTEM, LIFESTYLE BEHAVIOR ESTIMATION DEVICE, LIFESTYLE BEHAVIOR ESTIMATION PROGRAM, AND RECORDING MEDIUM**

(57)    An EoD system can be easily introduced in consideration of personal living activities. A current electric power value is received from a smart tap 11, a use state q of an appliance is estimated (A) from the current electric power value, change of the use state is detected as an event when the use state is different from a use state q' of a previous time, and the type of the event e{q' → q} and an occurrence time et are stored in a memory 10. Following that, a first weight p(q' → q|t, 1) of the living activity by the type of the event e is calculated based on an appliance function model table (1) 12b and an elapsed time from the event occurrence time et, and a second weight p(q|1) to each living activity corresponding to the current use state q of the appliance is acquired from an appliance function model table (2) 12c. Based on the product that is a multiplication of the first weight and the second weight, a sum Wl of the products is calculated for each appliance, and a living activity label, in which the sum Wl of the product values of each appliance becomes a maximum value, is estimated as a living activity label lt of a time t.

[ Fig.16 ]

**Description**

Technical Field

The present invention relates to a living activity estimation system, a living activity estimation device, a living activity estimation program, and a recording medium suitable for easy introduction of an EoD system in consideration of living activities of a user without impairing quality of life (hereinafter, referred to as "QoL") needed by the user through the daily life.

Background Art

Conventionally, an on-demand power control system for realizing energy management of a household or an office is known. This system attempts to make a complete change to switch a supplier-led "push type" power network to a user/consumer-led "pull-type" power network.

This system allows a home server to know "which demand from a device is the most important" by analogy according to a use form of the user, in response to power demands of appliances that are various household appliance products in a household, for example, demands of an air conditioner or lighting, and performs control to supply the power to an important appliance having the highest priority, that is, performs energy-on-demand control (hereinafter, referred to as "EoD control"). Hereinafter, this system is referred to as "EoD control system". This EoD control system is proposed by Professor Takashi MATSUYAMA of Kyoto University.

The greatest benefit of use of the system is that energy saving and $CO_2$ emissions reduction can be realized from a demand side. For example, this system enables a user-led scheme to allow only the power cut by 20% to flow by the EoD control when a user sets an instruction to cut an appliance rate by 20% to the home server in advance, and can realize the energy saving and $CO_2$ emissions reduction.

Meanwhile, a home energy management system (HEMS) that is a management technique of appliances is known. This HEMS performs automatic control, setting control rules of the appliances, such as to automatically stop the operation when an outdoor temperature is low in the case of an air conditioner. This system achieves the energy saving by optimizing the use method of the appliances, and is based on the use method of the appliances.

Because of focusing on the use method of the appliances, the conventional HEMS does not consider that how much power can be reduced by change of a use method of each appliance, and also cannot guarantee a power reduction rate that can satisfy requested electricity saving.

As Patent Literature related to the EoD control, an "on-demand power control system" described below is known (see Patent Literature 1).

This on-demand power control system is an on-demand power control system that includes a commercial power source, a plurality of appliances, smart taps connected to the appliances, a dynamic priority control device including a memory and performing supply control of power to the appliances, and a network to which the dynamic priority control device is connected through the smart taps, wherein the dynamic priority control device allocates a difference between instantaneous power of an initial desired value and actual instantaneous power to subsequent instantaneous power of the initial desired value to calculate an updated initial desired value, compares the updated initial desired value with maximum instantaneous power, when the updated initial desired value is smaller, updates the subsequent instantaneous power of the initial desired value as the updated initial desired value, and when the updated initial desired value is larger, updates the instantaneous power of the initial desired value as the maximum instantaneous power, thereby to set the updated initial desired value. Following that, at timing when having received a power demand message from the smart tap, the dynamic priority control device calculates an electric power consumption total value of an appliance that has transmitted the power demand message and an appliance in operation, calculates a priority between the both appliances, based on appliance characteristic class data, which is classified according to characteristics of power supply methods with respect to the appliances, compares the electric power consumption total value with the updated initial desired value, when the electric power consumption total value is smaller, supplies the power to the appliance that has transmitted the power demand message, when the electric power consumption total value is larger, calls the priority from the memory and selects an appliance having a minimum value of the priority, determines whether the appliance falls into any of the characteristics by reference to the appliance characteristic class data, and performs mediation, based on the priority between the appliances according to the appropriate characteristic of the appliance.

Accordingly, the priority between appliances can be changed according to an appliance needed by the user through daily life, and a use state of the appliance. Therefore, there is an advantage to be able to use a necessary appliance at necessary timing.

Further, the on-demand power control system has a characteristic of a power management technique. Therefore, the appliances are classified based on a power adjustment method, and power mediation means that guarantees an upper limit of the electric power consumption is introduced, thereby to guarantee an electricity saving rate and a peak reduction rate. Therefore, if the on-demand power control system is used instead of conventional HEMS, there is an advantage of coping with a problem of the current tight supply-demand balance.

Citation List

Patent Literature

Patent Literature 1: WO2013/008934 A1

Summary of Invention

Technical Problem

As described above, the "on-demand power control system" disclosed in Patent Literature 1 can change the priority between the appliances according to the use states of the appliances. Therefore, a necessary appliance can be used at necessary timing. In addition, by introducing the power mediation means that guarantees the upper limit of the electric power consumption, the "on-demand power control system" can guarantee the electricity saving rate and the peak reduction rate, and can cope with the problem of the current tight supply-demand balance.

However, the "on-demand power control system" disclosed in Patent Literature 1 knows an electricity saving effect only after the user introduces and uses the system. Therefore, there is a problem that the electricity saving effect cannot be obtained prior to the introduction of the system.

In addition, there is a problem that the introduction of the system in consideration of living activities of the user is difficult.

Therefore, it is desired to estimate living activities from electric power consumption of appliances, to verify an effect in advance by simulating the electric power consumption of the appliances, and to make introduction of the EoD system easy in consideration of personal living activities.

The present invention has been made in view of the foregoing, and an objective is to provide a living activity estimation system, a living activity estimation device, a living activity estimation program, and a recording medium that enables easy introduction of the EoD system in consideration of personal living activities.

Solution to Problem

In order to solve the above problems, there is provided a living activity estimation system including: at least one appliance installed in a predetermined space; a smart tap configured to supply electric power to the appliance; a living activity estimation device configured to estimate an event concerning the appliance, of living activities of a consumer in the space; and a network configured to connect the appliance and the living activity estimation device through the smart tap, wherein the living activity estimation device including appliance use state estimation means configured to estimate a use state of the appliance, based on an electric power value received from the appliance, event information detection means configured to detect event information in the space, based on the use state of the appliance at a certain point of time and the use state of the appliance at a previous point of time of the certain point of time, first weight acquisition means configured to acquire a first weight of each living activity by the event information, the first weight indicating relationship between change of the use state of the appliance and the living activity, from a first appliance function model table that holds the first weight, based on an elapsed time from a point of time of occurrence of the event, second weight acquisition means configured to acquire a second weight of each living activity, the second weight indicating relationship between the use state of the appliance and the living activity, from a second appliance function model table that holds the second weight, based on the use state of the appliance, appliance weight multiplication means configured to calculate, based on a product that is a multiplication of the first weight and the second weight, a sum of the products for each appliance, and living activity estimation means configured to estimate a living activity in which the sum of the products of each appliance becomes a maximum value, as an actual living activity of the consumer.

Advantageous Effects of Invention

According to the present invention, a living activity estimation device estimates a use state of an appliance, based on a power value received from the appliance, and detects event information in a space, based on the use state of the appliance at a certain point of time and the use state of the appliance at a point of time prior to the certain point of time. Then, the living activity estimation device acquires a first weight of each living activity according to the event information, from a first appliance function model table that holds the first weight indicating relationship between change of the use state of the appliance and the living activity, based on an elapsed time from a point of time of occurrence of the event, and acquires a second weight of each living activity from a second appliance function model table that holds the second weight indicating relationship between the use state of the appliance and the living activity, based on the use state of the appliance. Then, based on a product of a multiplication of the first weight and the second weight, the living activity estimation device calculates a sum of the products for each appliance, and estimates a living activity in which the sum of the products of each appliance becomes a maximum value, as an actual living activity of a consumer. Thereby, the living activity estimation device can estimate the living activities from the electric power consumption of the appliance, whereby the EoD system can be easily introduced in consideration of personal living activities.

Brief Description of Drawings

Fig. 1 is a schematic diagram illustrating a configuration of a communication network of an EoD control system to which a living activity estimation device according to a first embodiment of the present invention is adaptable.

Fig. 2 is a schematic diagram illustrating a configuration of a power system network of the EoD control system 50 illustrated in Fig. 1.

Fig. 3 is an explanatory diagram describing arrangement positions from STs connected to the receptacles in a household to the devices.

Fig. 4 is an explanatory diagram for describing connection relationship among the receptacle connected to a commercial power source and arranged on a wall, a smart tap 11, and the device.

Fig. 5 is a floor plan illustrating a floor plan of a model house used in examples of information processing of the EoD control system and demonstration experiments described below.

Fig. 6 is a graph illustrating electric power consumption used by devices in a house.

Fig. 7 is a graph illustrating electric power consumption that is integration of electric power consumption used by appliances.

Fig. 8 is a diagram illustrating an outline of a life model for describing a principle of the present invention.

Fig. 9 is a diagram illustrating a processing outline in the principle of the present invention.

Fig. 10 is a diagram for describing a living activity model in the principle of the present invention.

Fig. 11(a) is a diagram illustrating survey details of a conventional questionnaire, and Fig. 11(b) is a diagram illustrating items of a questionnaire employed in the present embodiment.

Fig. 12 is a diagram for describing an electric power pattern of appliances.

Fig. 13 is a diagram for describing a method of acquiring a personal model.

Fig. 14 is a diagram for describing an appliance function model.

Fig. 15 is a block diagram for describing a configuration of a living activity estimation device 1 according to a first embodiment of the present invention.

Fig. 16 is a flowchart (part 1) for describing an operation of the living activity estimation device 1 according to the first embodiment of the present invention.

Fig. 17 is a diagram for describing a configuration of an appliance function model table (1).

Fig. 18 is a diagram for describing a configuration of an appliance function model table (2).

Fig. 19 is a diagram illustrating an outline of living activity estimation processing with the appliance function model table.

Fig. 20 is a block diagram for describing a configuration of the living activity estimation device 1 according to the first embodiment of the present invention.

Fig. 21 is a flowchart (part 2) for describing an operation of the living activity estimation device 1 according to the first embodiment of the present invention.

Fig. 22 is a diagram illustrating state transitions of the appliances.

Figs. 23(a) and 23(b) are diagrams for describing configurations of appliance use state transition probability tables.

Figs. 24(a) and 24(b) are diagrams for describing configurations of use state persistence length probability tables.

Figs. 25(a) and 25(b) are diagrams for describing configurations of appliance use frequency tables.

Figs. 26(a) to 26(d) are diagrams for describing configurations of the appliance use frequency tables.

Fig. 27 is a diagram illustrating a result example of living activity estimation processing.

Fig. 28 is a diagram illustrating a result example of the living activity estimation processing.

Fig. 29 is a processing outline diagram for describing an electric power consumption simulation.

Fig. 30 is an outline diagram for describing an appliance use model.

Fig. 31 is a block diagram for describing a configuration of a living activity estimation device according to a second embodiment of the present invention.

Fig. 32 is a flowchart for describing an operation of a living activity estimation device 1 according to the second embodiment of the present invention.

Fig. 33 is a diagram illustrating a result example of a simulation.

Fig. 34 is a diagram illustrating a result example of a simulation.

Fig. 35 is a diagram illustrating a result example of a simulation.

Fig. 36 is a diagram illustrating a result example of a simulation.

Fig. 37 is a block diagram illustrating a configuration of an LAPC model.

Fig. 38 is a schematic diagram illustrating an example of flat (small change) depiction.

Fig. 39 is a flowchart for generating an electric power consumption pattern in each time (second) for each appliance by using the LAPC model.

Fig. 40 is a diagram illustrating to cut a period due to termination of each appliance state.

Fig. 41 is a diagram illustrating dependent relationship between two consecutive duration times.

Fig. 42 is a block diagram for describing a configuration of a living activity estimation device according to a third embodiment of the present invention.

Fig. 43 is a diagram illustrating probabilities based on an appliance function and learned probabilities for evaluating one day of a participant A.

Fig. 44 is a diagram illustrating a layout of the house in which the appliances are arranged.

Figs. 45(a) to 45(c) are schematic diagrams illustrating sequences of the living activities of one day of the participant A.

Fig. 46 is a diagram illustrating recall, precision, and F-measure about estimated living activities.

Figs. 47(a) to 47(c) are diagrams illustrating actual and generated electric power consumption patterns of the first day of the participant A.

Description of Embodiments

Hereinafter, embodiments of the present invention will be described with reference to the drawings.

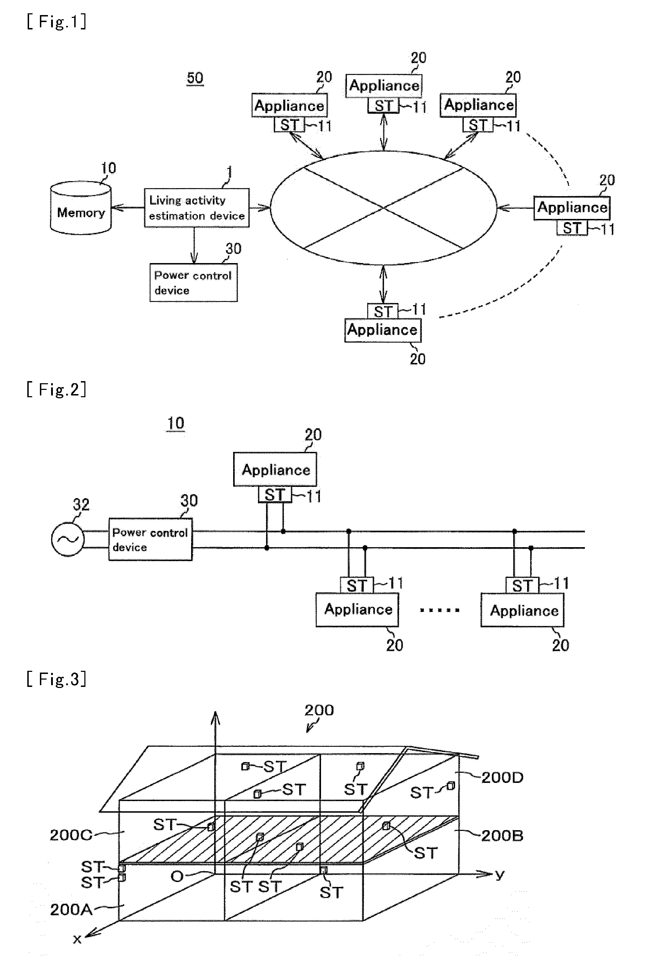

A configuration of a communication network of an EoD control system adaptable to a living activity estimation system according to an embodiment of the present invention will be described with reference to Fig. 1.

Fig. 1 is a schematic diagram illustrating a configuration of a communication network of an EoD control system to which a living activity estimation device according to a first embodiment of the present invention is adaptable. An EoD control system 50 is installed in an office or a household, and is configured from a living activity estimation device 1, smart taps 11, appliances 20 (hereinafter, simply referred to as "devices") that are household or office appliance products, and a power control device 30. The smart tap 11 (hereinafter, referred to as "ST") is connected to the living activity estimation device 1 through a local area network (LAN) by wire or a wireless LAN. The LAN is an example of the present invention and is not limited thereto. In the present invention, the living activity estimation device 1 may be connected to the ST through a network such as WiFi, PLC, ZigBee, or specified low power radio. The LAN is connected to the ST through a power receptacle of each device. Therefore, the ST can communicate with the living activity estimation device 1 through the LAN.

The living activity estimation device 1 is a general purpose server, and includes a CPU 1a. The living activity estimation device 1 includes a memory 10 (hereinafter, simply referred to as "memory") in its inside, and the memory is a semiconductor storage device such as a directly readable/writable hard disk or RAM.

Electric power from a commercial power source is supplied to the living activity estimation device 1 and devices 20 through the power control device 30.

Note that an ordinary household will be described as an installation place of the EoD control system 50. However, the installation place is not limited thereto, and any place may be employed as long as the ST can be installed, such as an office. Further, an external ST that is connected to the power receptacle will be described as the ST of the EoD control system of the present invention. However, the ST is not limited thereto, and a built-in ST embedded in the power receptacle may be employed.

Fig. 2 is a schematic diagram illustrating a configuration of a power system network of the EoD control system 50 illustrated in Fig. 1.

As described with reference to Fig. 1, the EoD control system 50 includes the power control device 30, and a commercial power source 32 is connected to the power control device 30. Further, the power control device 30 is configured from a plurality of breakers (not illustrated), for example, and includes one main breaker and a plurality of sub breakers. The power (alternating current voltage) from the commercial power source 32 is provided to a primary side of the main breaker, and is distributed from a secondary side of the main breaker to the plurality of sub breakers. Note that the commercial power source 32 is connected to the primary side of the main breaker through a switch (not illustrated) for supplying/stopping a commercial current. This switch is turned on/off by a switch signal of the living activity estimation device.

Further, the living activity estimation device 1 and the plurality of devices 20 as described above are connected to an output side of the power control device 30, that is, secondary sides of the sub breakers. Although not illustrated, the living activity estimation device 1 is connected such that electric power from the power control device 30 can be supplied by inserting an attachment plug provided in its device into a wall socket or the like. For the plurality of devices, the STs include input receptacles as attachment plugs and output receptacles. The plurality of devices is connected such that electric power of the commercial power source 32 is sent from the input receptacle, and can be supplied to the plurality of devices through receptacles of the plurality of devices connected to the output receptacles.

As described above, in the EoD control system, not only the power network illustrated in Fig. 2, but also the communication network illustrated in Fig. 1 are constructed.

Fig. 3 is an explanatory diagram describing arrangement positions from the STs connected to the receptacles in a household to the devices.

Referring to Fig. 3, a house 200 is configured from a living room 200A, a Japanese-style room 200B, and western-style rooms 200C and 200D, for example. The living room 200A and the Japanese-style room 200B are arranged on the first floor, and the western-style rooms 200C and 200D are arranged on the second floor. As illustrated in Fig. 3, the STs are respectively connected to the receptacles installed on walls. For example, five STs are connected to the receptacles installed on the walls of the living room 200A, two STs are connected to the receptacles installed on the walls of the Japanese-style room 200B, two STs are connected to the receptacles installed on the walls of the western-style room 200C, and two STs are connected to the receptacles installed on the walls of the western-style room 200D. As described above, all of the devices are connected to a power source through the STs.

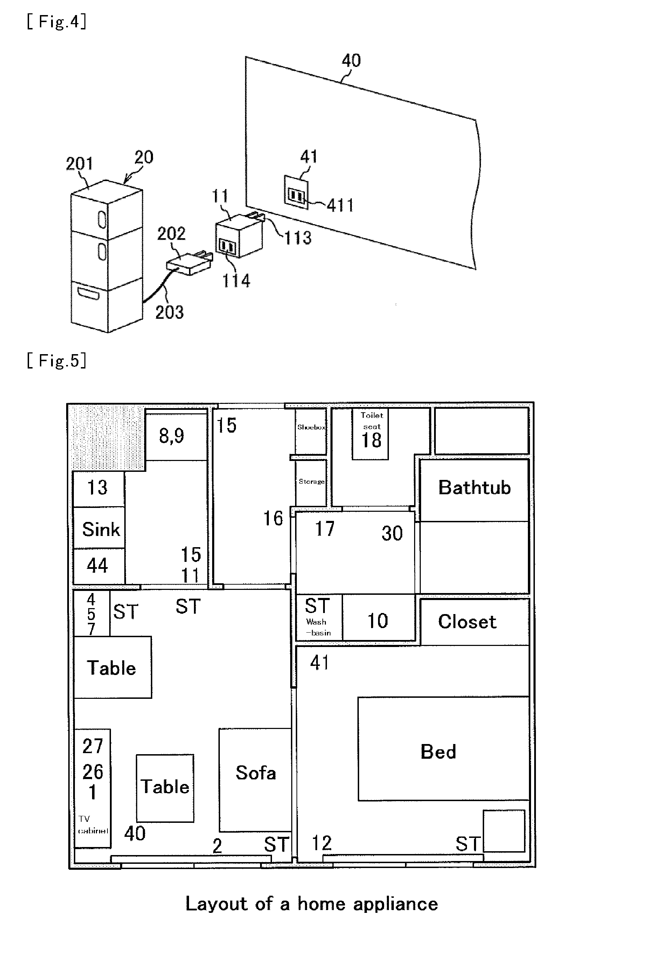

Fig. 4 is an explanatory diagram for describing connection relationship among the receptacle connected to the commercial power source and arranged on the wall, the smart tap 11, and the device. Referring to Fig. 4, a refrigerator 201 as a device is configured from a receptacle 202 including an attachment plug and wiring 203, and the receptacle 202 of the refrigerator 201 is attached/detached to/from an outlet receptacle 114 of the ST. A receptacle 41 is arranged on a wall 40, and the commercial electric power is supplied to an insertion port 411 of the receptacle 41 through an electric power system in the household. An input receptacle 113 as an attachment plug is attached/detached to/from the insertion port 411.

Fig. 5 is a floor plan illustrating a floor plan of a model house used in examples of information processing of the EoD control system and demonstration experiments thereof which will be described below.

The model house is a one-bedroom type house, and the numbers illustrated in the drawing represent names of the devices illustrated in Table 1 and places where switches of the devices are installed. The STs illustrated in the drawing represents places where the smart taps 11 are arranged. The five STs are arranged.

[Table 1]

| id | name | id | name | id | name |
|----|------|----|------|----|------|
| 1 | TV | 12 | Bedroom light | 30 | Bathroom light and fan |
| 2 | Air conditioner | 13 | Kitchen light 1 | 40 | Electric carpet |
| 4 | Pot | 15 | Corridor light | 41 | Heater |
| 5 | Coffee maker | 16 | Wash-basin light | 42 | Router |
| 6 | Night stand | 17 | Restroom light and fan | 43 | Video |
| 7 | Rice cooker | 18 | Washlet | 44 | IH |
| 8 | Refrigerator | 20 | Air cleaner | 45 | Battery charger |
| 9 | Microwave | 21 | Vacuum cleaner | 46 | Notebook PC |
| 10 | Washing machine | 22 | Dryer | | |
| 11 | Living room light and kitchen light 2 | 24 | Electric toothbrush | | |

As for a structure of the ST, as described above, the ST is configured from a voltage/current sensor, a semiconductor relay, a ZigBee module, and a microcomputer that performs overall control and internal processing. The microcomputer calculates electric power consumption from current/voltage waveforms measured by the voltage/current sensor, and identifies an appliance from a few characteristic amounts that indicate characteristics of the voltage/current waveforms. Data received by the EoD control system are two data, which are electric power consumption and a power demand message. The electric power consumption is calculated by the ST at 0.5-second intervals using the microcomputer, held in a memory provided inside the smart tap as data of each period (once/60 seconds), and divided into a plurality of packets and transmitted to a server. The power demand message is transmitted from the ST when each device 20 requests the electric power.

Although not illustrated, the living activity estimation device 1 includes a memory of a program storage region and a data storage region. In the program storage region, programs such as a communication processing program and a living activity estimation program are stored. In the data storage region, device characteristic class data, message data, and the like are stored.

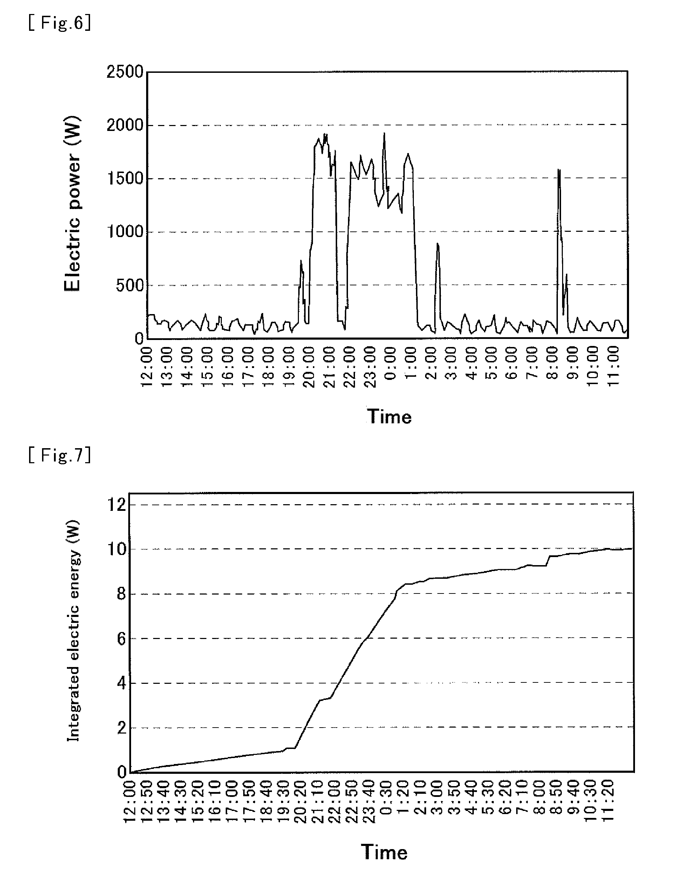

Fig. 6 is a diagram illustrating a graph of the electric power consumption used by devices in a house.

In Fig. 6, the vertical axis represents the electric power (W), and the horizontal axis represents time. The graph indicates the electric power consumption consumed at 10-minute intervals in one day. Up to now, the electric power has been called electric power consumption. However, the electric power has a different meaning from general "electric power consumption". Therefore, hereinafter, a defined term "instantaneous power" will be used. The instantaneous power means electric power consumption that is an average of total values obtained by adding up of the electric power consumption at minimum control intervals $\tau$ (5 to 10 minutes).

From the graph, it can be seen that the electric power is not used in daytime hours, and the electric power is used in hours from 8 p.m. to 1 a.m., and value of the instantaneous power during the hours is 1900W as high.

In Fig. 7, the vertical axis represents electric energy consumption (KWh), and the horizontal axis represents time. The graph illustrates electric energy consumption that is an integrated amount of the instantaneous power at 10-minute intervals in one day, and a value thereof is 10.0 KWh.

The electric energy consumption per month per household in Japan is 300 KWh, and about 10.0 kWh per day. It is shown that the electric energy consumption of Fig. 7 is the same as the electric energy consumption per month per household. Up to now, the integrated amount of the electric power has been called electric energy consumption. However, the instantaneous power is used in a different meaning from the general "electric power consumption". Therefore, the electric energy consumption has a different meaning from the general meaning, and hereinafter, a defined term called "integrated electric energy" will be used hereinafter.

An overall model for describing a principle of the present invention will be described.

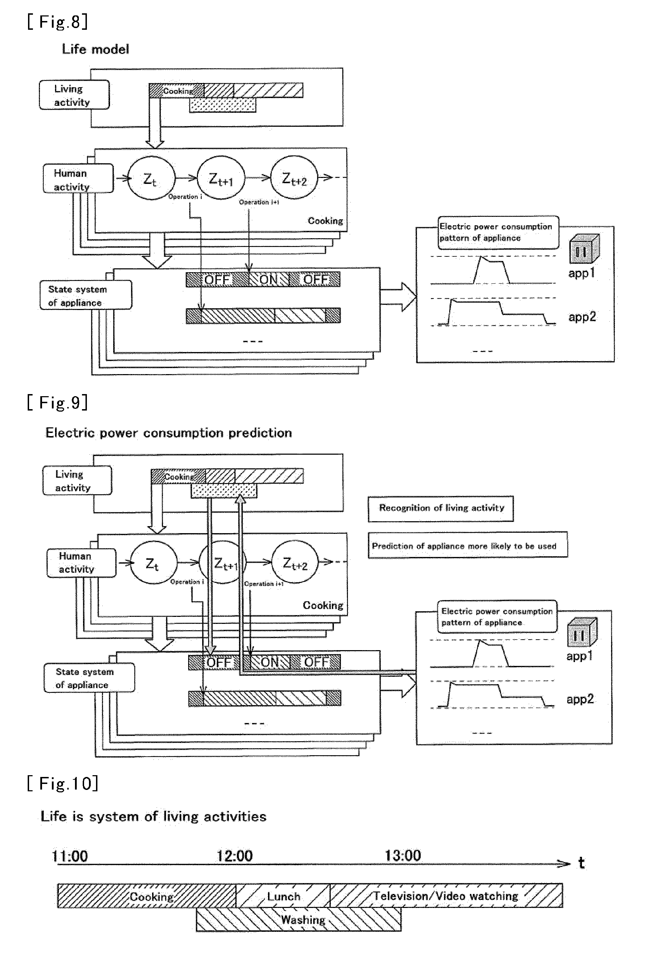

First, an overall model outline will be described with reference to Fig. 8.

The living activity estimation device will be described in detail in first and second embodiments.

First, a processing outline diagram illustrated in Fig. 9 will be described.

Fig. 9 illustrates a schematic processing flow from living activity estimation processing to electric power consumption prediction processing, based on the electric power consumption of the appliances.

In personal life, a living activity such as cooking is performed.

In the first embodiment, a living activity estimation device acquires an electric power consumption pattern of the appliance used by a person (consumer) online in real time, thereby to estimate a state system of the appliance (an ON/OFF state, a strong/weak state, and the like), and then to estimate an appliance more likely to be used next.

In the second embodiment, a living activity estimation device generates an electric power consumption pattern that indicates an electric power value, according to probability distribution of a next use state, by using questionnaire information for estimating living activities of a consumer in a life space.

Next, a living activity model will be described with reference to Fig. 10.

In personal living activities, types of activities on life, which are given meanings as personal awareness include "cooking", "washing", "television/video watching", and the like, and temporal parameters such as "when" and "how long" are attached thereto. Therefore, an i-th living activity $I_i^L$ is:

$$I_i^L = <l_i, t_i^{start}, t_i^{end}>$$

where the living activity names such as "cooking", "washing", and "television/video watching" are living activity labels $l_i$, a start time is $t_i^{start}$, and an end time is $t_i^{end}$.

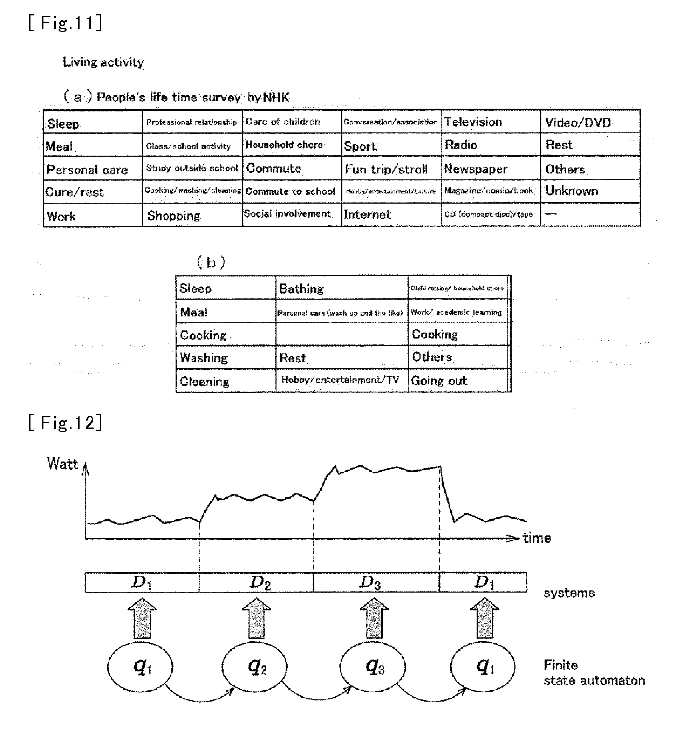

Next, the living activity model will be described with reference to Figs. 11(a) and 11(b).

Fig. 11 (a) illustrates questionnaire survey details about a people's life time survey conducted by Japan Broadcasting Corporation (NHK), and the survey also includes items during going out, which are away from a living environment.

In contrast, in the questionnaire employed in the present embodiment, as illustrated in Fig. 11(b), basic personal activities in the living environment such as "sleep", "meal", and "cooking" are employed as questionnaire items, and a case away from the living environment is treated as going out.

Next, an electric power pattern of an appliance will be described with reference to Fig. 12.

In an electric power variation model of an appliance, electric power data of the appliance is treated as a plurality of discrete states, and is also treated as a continuous time system because the appliance is continuously used in a certain period.

To be specific, the electric power data is expressed as time section <qi, $\tau$i> obtained by adding a persistence time $\tau$ to an operation mode qi of a certain appliance.

$$<qi, \tau i> \rightarrow <qj, \tau j>$$

Next, an appliance relationship model will be described.

In the appliance relationship model that indicates relationship between the personal living activities and an appliance in real life, an appliance function model is considered as typical characteristic expression. In the appliance function model, such a prior knowledge as what kind of living activity being related to a function of an appliance is necessary. Therefore, recognition of personal living activities is essential.

As an expression of personality, in an appliance use model, an electric power pattern is generated, and an appliance to be used is predicted by learning correspondence between the personal living activities and how to use the appliances, which characterizes the personal living activities.

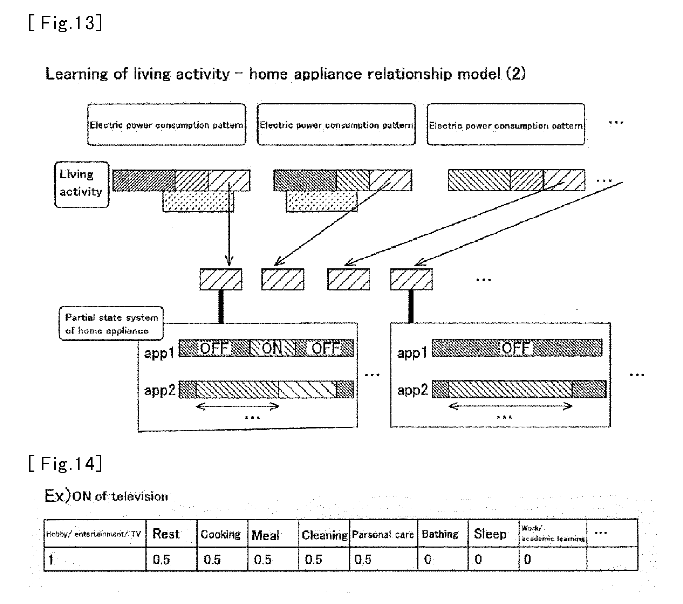

Next, a method of acquiring a personal model (a table other than the appliance function model) will be described with reference to Fig. 13.

A use probability P of an appliance is defined as:

$$P(U_a = 1 | l)$$.

Here, Ua is defined as 1 when an appliance a is used, and defined as 0 when the appliance a is not used. How frequently the appliance a is used is expressed by the probability, where the living activity label is l.

<First Embodiment>

A living activity estimation system according to a first embodiment of the present invention will be described.

Next, the appliance function model illustrated in Fig. 14 will be described.

The appliance function model indicates how an appliance can be used with respect to the personal living activities, which is determined according to functionality of the appliance. Assume that the appliance function model is held as the prior knowledge.

Here, probabilities $P_0$ are:

$$P_0(l | q_j^a)$$

$$P_0(l | q_j^a \rightarrow q_i^a)$$

where a living activity label set l, an appliance set a, and an appliance state set $q^a$ are respectively:

$$l = \{l_1, \ldots l_{N_l}\},$$

$$a = \{a_1, \ldots a_{N_a}\},$$

and

$$q^a = \{q_1^a, \ldots q_{K_a}^a\}.$$

The appliance function model indicates, as illustrated in Fig. 14, which living activity is performed when which appliance is in an operation state in the personal life. For example, a television is turned ON, the probability of hobby/entertainment television becomes 1, the probability of rest becomes 0.5, the probability of cooking becomes 0.5, the probability of cleaning becomes 0.5, and the like.

Next, the appliance use model will be described.

A use probability P of an appliance in the appliance use model is defined as:

8

$$P(U_a = 1 | l)$$

Here, Ua is defined as 1 when the appliance a is used, and defined as 0 when the appliance a is not used. How frequently the appliance a is used is expressed by the use probability P, where the living activity label is l.

Meanwhile, contribution C (a|l$_i$) of an appliance indicates how much the appliance a is distinctive for a personal living activity, and is expressed by:

$$C(a|l_i) = P(U_a = 1 | l = l_i)/P(U_a = 1 | l \neq l_i)$$

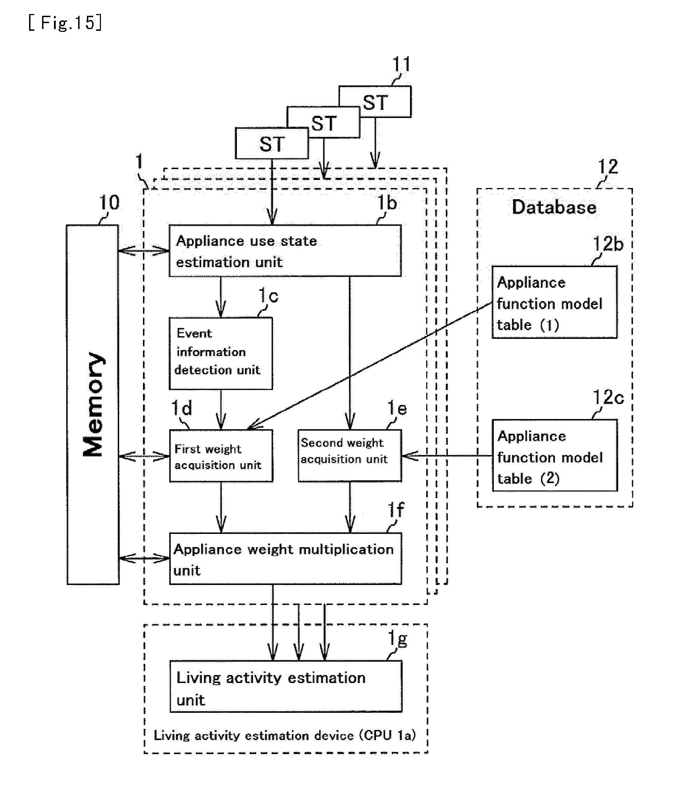

A configuration of the living activity estimation device 1 according to the first embodiment of the present invention will be described with reference to the function block diagram illustrated in Fig. 15.

The living activity estimation device 1 is configured from an appliance use state estimation unit 1b, a first weight acquisition unit 1d, a second weight acquisition unit 1e, an appliance weight multiplication unit 1f, and a living activity estimation unit 1g, which are made of software modules that are programs executed by the CPU 1a. Each unit performs read/write of data using the memory 10 as a work area during operation.

Further, a database 12 is configured from an appliance function model table (1) 12b and an appliance function model table (2) 12c, which are stored on a hard disk HDD, for example.

The appliance use state estimation unit 1b estimates a use state of each appliance, based on electric power values received from a plurality of appliances through the smart taps 11 and the network. The appliance event information detection unit 1c detects an event type (event information) that indicates a living activity in the living space, based on the use state of each current appliance and the use state of each appliance of a previous time.

The first weight acquisition unit 1d calculates a first weight of each living activity according to the event type, based on the appliance function model table (1) 12b that holds the first weight that indicates relationship between change of the use state of the appliance and the living activity, and an elapsed time from an event occurrence time.

The second weight acquisition unit 1e acquires a second weight of each living activity from the appliance function model table (2) 12c that holds the second weight that indicates relationship between the use state of the appliance and the living activity, based on the current use state of each appliance.

The appliance weight multiplication unit 1f calculates a sum of the products for each appliance, based on the product that is a multiplication of the first weight and the second weight. The living activity estimation unit 1g estimates a living activity having a maximum sum of the products of each appliance, as an actual living activity of the consumer.

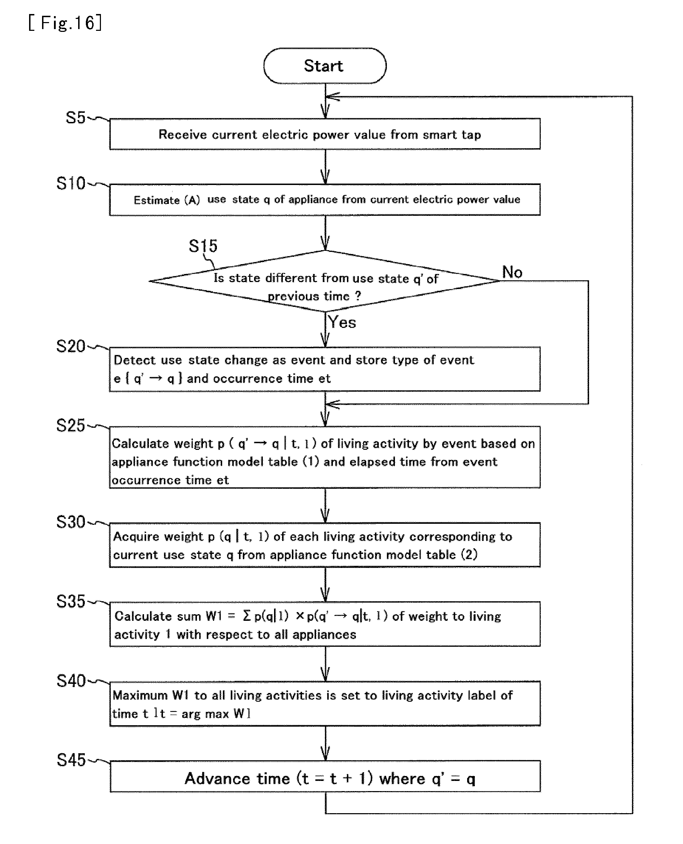

Next, an operation (part 1) of the living activity estimation device 1 illustrated in Fig. 15 will be described with reference to the flowchart illustrated in Fig. 16.

First, at step S5, the appliance use state estimation unit 1b receives the current electric power value from the smart tap 11, and stores the received value in the memory 10.

Following that, at step S10, the appliance use state estimation unit 1b estimates (A) a use state q of the appliance from the current electric power value, and stores the estimated result in the memory 10.

Following that, at step S15, the appliance event information detection unit 1c determines whether the use state q is different from a use state q' of a previous time read from the memory 10. When the use state q is different from the use state q' of the previous time, the appliance event detection unit 1c proceeds to step S20. Meanwhile, when the use state q is the same as the use state q' of the previous time, the appliance event detection unit 1c proceeds to step S25.

Following that, at step S20, the appliance event information detection unit 1c detects use state change as an event, and stores the type of the event e{q' → q} and an occurrence time et in the memory 10.

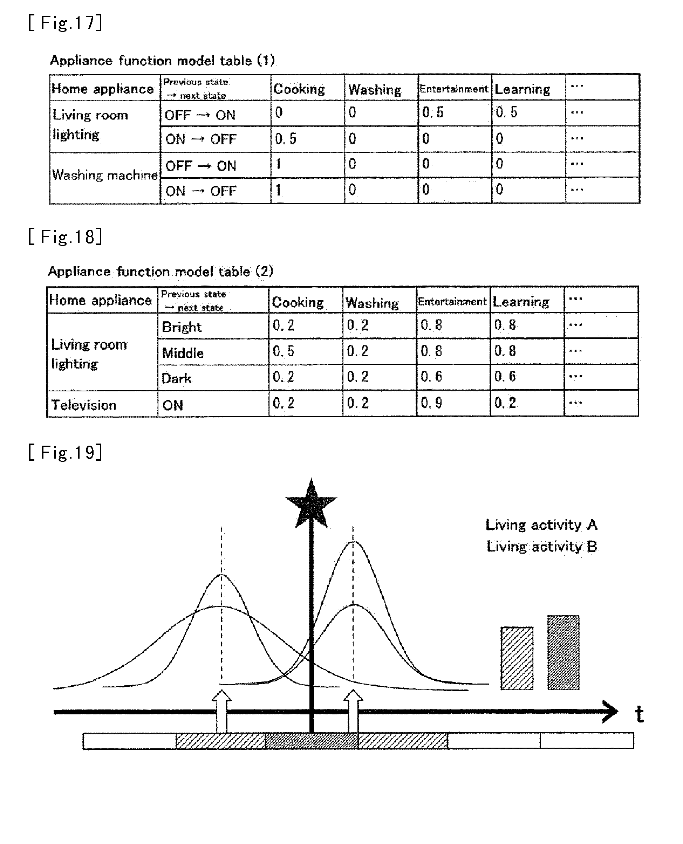

Following that, a configuration of the appliance function model table (1) will be described with reference to Fig. 17.

The appliance function model table (1) 12b indicates relationship between use state change of the appliance (for example, an input of a power source switch, and the like), and the living activities. For example, the table indicates the first weight "0" as no relationship, and the first weight "1" as strong relationship.

To be specific, in the appliance function model table (1) 12b, the appliance, the previous state → the next state, and the living activities such as cooking, washing, entertainment, an learning are written as items. For example, when living room lighting is turned OFF → ON, the weight values of the living activities such as entertainment and learning are set to 0.5. Meanwhile, when the living room lighting is turned ON → OFF, the weight value of the living activity of cooking is set to 0.5.

At step S25, the first weight acquisition unit 1d acquires the first weight p(q' → q|t, 1) of the living activities according to the type of the event e from the appliance function model table (1) 12b, based on the elapsed time from the event occurrence time et, and stores the acquired information in the memory 10.

To be specific, the first weight acquisition unit 1d acquires the weight values of the living activities such as cooking, washing, entertainment, and learning, as 0, 0, 0.5, 0.5, ..., when the living room lighting is turned OFF → ON, for example, based on the elapsed time from the event occurrence time et, when the use state q is different from the use state q' of the previous time, and stores the acquired values in the memory 10.

Following that, a configuration of the appliance function model table (2) will be described with reference to Fig. 18.

The appliance function model table (2) 12c indicates relationship between the use state (weak, middle, strong) of the appliance and the living activities, and for example, the table indicates the second weight "0" as no relationship, and the second weight "1" as strong relationship. As described above, the appliance function model table (2) 12c indicates which living activity is performed when which appliance is in an operation use state in the personal life.

To be specific, in the appliance function model table (2) 12c, the appliance, the previous state → the next state, and the living activities such as cooking, washing, entertainment, and learning are written as items. For example, the respective weights of when the living room lighting is bright are set to 0.2 in the cooking, 0.2 in the washing, 0.8 in the entertainment, and 0.8 in the learning.

At step S30, the second weight acquisition unit 1e acquires the second weight $p(q|l)$ to each living activity corresponding to the current use state q of the appliance from the appliance function model table (2) 12c, and stores the acquired information in the memory 10.

To be specific, the second weight acquisition unit 1e acquires the weight values of the living activities such as cooking, washing, entertainment, and learning, as 0.2, 0.2, 0.8, 0.8, ..., when the living room lighting is bright, for example, based on the current use state q of the appliance, and stores the acquired values in the memory 10.

An outline diagram of the living activity estimation processing with the appliance function model table 12b illustrated in Fig. 19 will be described.

When recognizing a living activity, a probability related to the living activity is estimated in a maximum likelihood manner for each operation of an event appliance from an appliance function model. For example, a time width $\tau$ from one to several minutes is provided, and a weight p is provided to the appliance a in operation for each living activity label 1 that falls within the time width $\tau$, a living activity having a maximum sum of the weights is identified as the living activity.

At step S35, the appliance weight multiplication unit 1f calculates a sum Wl of the products with respect to the living activity 1 for all of the appliances, based on the product that is a multiplication of the first weight and the second weight, by $Wl=\sum p\,(q|l) \times p(q' \to q|t,l)$ and stores the calculation result in the memory 10.

That is, the appliance weight multiplication unit 1f reads the second weight $p(q|l)$ to each the living activities corresponding to the current use state q of the appliance acquired at step S30 from the memory 10. For example, when the living room lighting is bright, the appliance weight multiplication unit 1f reads the weight values 0.2, 0.2, 0.8, 0.8, ... of the living activities such as cooking, washing, entertainment, and learning, from the memory 10.

Following that, the appliance weight multiplication unit 1f reads the first weight $p(q' \to q|t, 1)$ of the living activities according to the type of the event e calculated at step S25 from the memory 10. For example, when the living room lighting is turned OFF → ON, the weight values 0, 0, 0.5, 0.5, ... of the living activities such as cooking, washing, entertainment, and learning are read from the memory 10.

Following that, the appliance weight multiplication unit 1f multiplies the first weight and the second weight for each electric power device, calculates the sum Wl of the products for each appliance, based on the obtained product values, and stores the calculation result in the memory 10.

To be specific, when the living room lighting is turned OFF → ON, the first weights of the living activities such as cooking, washing, entertainment, and learning are 0, 0, 0.5, 0.5, ..., respectively, and when the living room lighting is bright, the second weights of the living activities such as cooking, washing, entertainment, and learning are 0.2, 0.2, 0.8, 0.8, ..., respectively. Therefore, the product values of the living activities such as cooking, washing, entertainment, and learning multiplied by the appliance weight multiplication unit 1f are 0, 0, 0.4, 0.4, ..., respectively, with respect to the living room lighting.

Following that, the appliance weight multiplication unit 1f also obtains the multiplication results about the living activities such as cooking, washing, entertainment, and learning, about the appliances such as a washing machine, a television, and a dryer, similarly to the multiplication about the living room lighting. To be specific, assume that the multiplication results of the washing machine are 0, 0, 0, 0, ..., the multiplication results of the television are 0, 0, 0.9, 0.2, ..., and the multiplication results of the dryer are 0, 0, 0, 0, ..., for example.

Following that, the appliance weight multiplication unit 1f calculates the sum of the products of each living activity, with respect to the products of each appliance. To be specific, the sum values about the living activities such as cooking, washing, entertainment, and learning are 0, 0, 1.3, and 0.6, respectively.

Following that, at step S40, the living activity estimation unit 1g estimates the living activity label having the maximum sum Wl of the product values of each appliance, as a living activity label lt of a time t, and stores the estimated result in the memory 10.

$$lt = arg\ max\ Wl$$

The appliance weight multiplication unit 1f estimates the living activity having the maximum sum value, as the actual living activity of the consumer. To be specific, the sum values are 1.3 in the entertainment, 0.6 in the learning, ... in descending order. Therefore, the appliance weight multiplication unit 1f estimates the entertainment as the actual living activity of the consumer.

Following that, at step S45, the living activity estimation unit 1g advances the time (t = t + 1) where q' = q, returns to step S5, and repeats the processing illustrated in steps S5 to S45.

As a result, the current living activity can be estimated from the electric power values obtained from the smart taps.

According to the present invention, the living activity estimation device 1 estimates a use state of an appliance, based on a power value received from the appliance, and detects event information in a space, based on the use state of the appliance at a certain point of time and the use state of the appliance at a point of time before the certain point of time. Then, the living activity estimation device acquires a first weight of each living activity according to the event information, from a first appliance function model table that holds the first weight indicating relationship between change of the use state of the appliance and the living activity, based on an elapsed time from a point of time of occurrence of an event, and acquires a second weight of each living activity from a second appliance function model table that holds the second weight indicating relationship between the use state of the appliance and the living activity, based on the use state of the appliance. Then, the living activity estimation device calculates a sum of the products for each appliance, based on the product of multiplication of the first weight and the second weight, and estimates a living activity having a maximum value of the sum of the products of each appliance as an actual living activity of a consumer. Therefore, the living activity estimation device can estimate the living activities from the electric power consumption of the appliance, whereby the EoD system can be easily introduced in consideration of personal living activities.

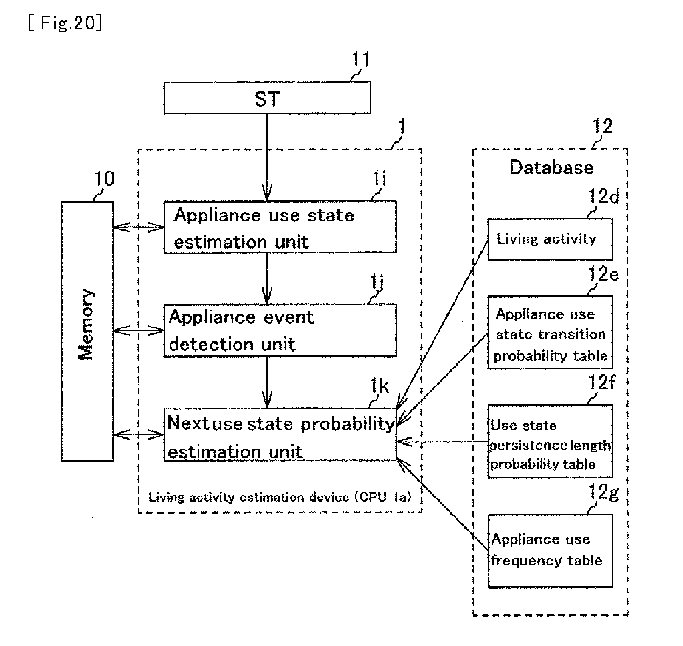

A configuration of the living activity estimation device 1 according to the first embodiment of the present invention will be described with reference to the function block diagram illustrated in Fig. 20.

The living activity estimation device 1 is configured from an appliance use state estimation unit 1i, an appliance event detection unit 1j, and a next use state probability estimation unit 1k, which are made of software modules that are programs executed by the CPU 1a, and each unit performs read/write of data using the memory 10 as a work area during the operation.

The appliance use state estimation unit 1i estimates a use state of each appliance, based on electric power values received from a plurality of appliances. The appliance event detection unit 1j detects an event type that indicates a living activity in the living space, based on the use state of each current appliance and the use state of each appliance of a previous time.

The next use state probability estimation unit 1k acquires a transition probability of the next use state from an appliance use state transition probability table that indicates a probability of transition of the use state of the appliance to another use state, acquires a transition probability corresponding to an elapsed time after occurrence of an event from a use persistence length probability table that indicates a time probability of persistence of the use state, based on the transition probability of the next use state, and calculates probability distribution of an appliance to be operated in the next use state, based on the transition probability corresponding to a next use state transition probability and the elapsed time.

The next use state probability estimation unit 1k acquires an application use frequency with respect to a living activity label from an application use frequency table that indicates a probability of using the appliance for each living activity when the appliance is not being used, and acquires initial use state distribution from the appliance use state transition probability table that indicates a probability of transition of the use state of the appliance to another use state.

Further, the database 12 is configured from living activities 12d, an appliance use state transition probability table 12e, a use state persistence length probability table 12f, and an appliance use frequency table 12g, which are stored on a hard disk HDD, for example.

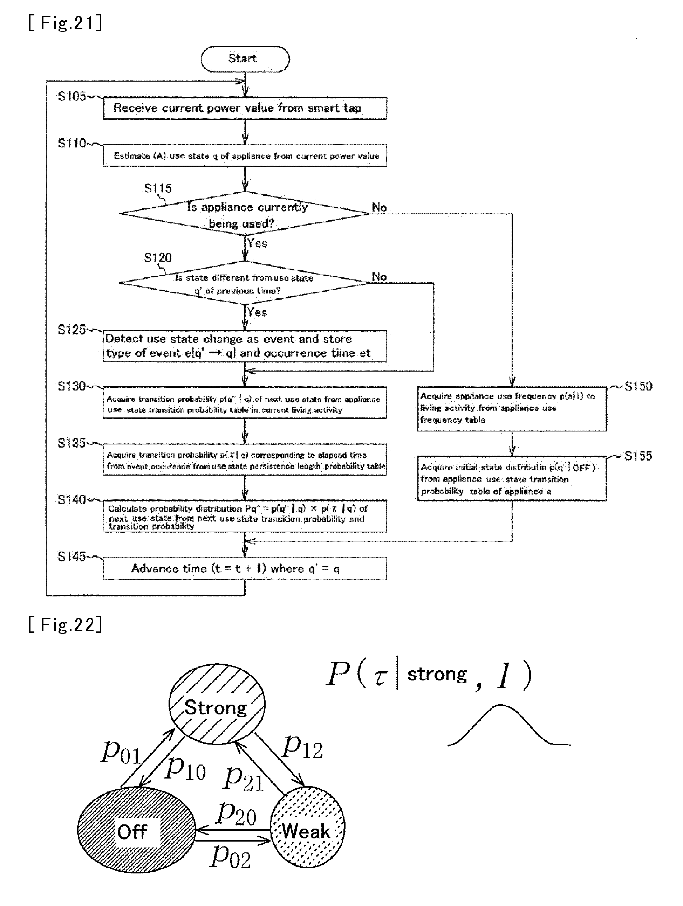

Next, an operation (part 2) of the living activity estimation device 1 illustrated in Fig. 20 will be described with reference to the flowchart illustrated in Fig. 21.

First, in Fig. 22, how long and in which order the appliance a is operated are indicated by a probability time automaton. As illustrated in Fig. 22, in the probability time automaton, a case is assumed, in which the appliance a makes a transition among three use states of an off state, a weak state, and a strong state, as time passes, for example.

An operation pattern of the appliance in a time section $\tau$ in which the living activity label is 1 is expressed by:

$$P(\tau \mid \text{strong}, l)$$

with respect to the strong state.

A state transition probability P is expressed by:

$$P(q_j^a \mid l, q_i^a)$$

State persistence length distribution P is expressed by:

$$P(\tau_i \mid l, q_i^a)$$

Initial state distribution Ps is expressed by:

$$P_s(q_i^a \mid l)$$

First, at step S105, the appliance use state estimation unit 1i receives the current electric power value from the smart tap 11, and stores the received value in the memory 10.

Following that, at step S110, the appliance use state estimation unit 1i estimates (A) the use state q of the appliance from the current electric power value and stores the estimated value in the memory 10.

Following that, at step S115, the appliance event detection unit 1j determines whether the appliance is currently being used. Here, when the appliance is currently being used, the appliance event detection unit 1j proceeds to step S120. Meanwhile, when the appliance is not currently being used, the appliance event detection unit 1j proceeds to step S150.

Following that, at step S120, the appliance event detection unit 1j determines whether the use state q is different from the use state q' of the previous time read from the memory 10. When the use state q is different from the use state q' of the previous time, the appliance event detection unit 1j proceeds to step S125. Meanwhile, when the use state q is the same as the use state q' of the previous time, the appliance event detection unit 1j proceeds to step S130.

At step S125, the appliance event detection unit 1j detects the use state change as an event, and stores the type of the event e{q' → q} and the occurrence time et in the memory 10.

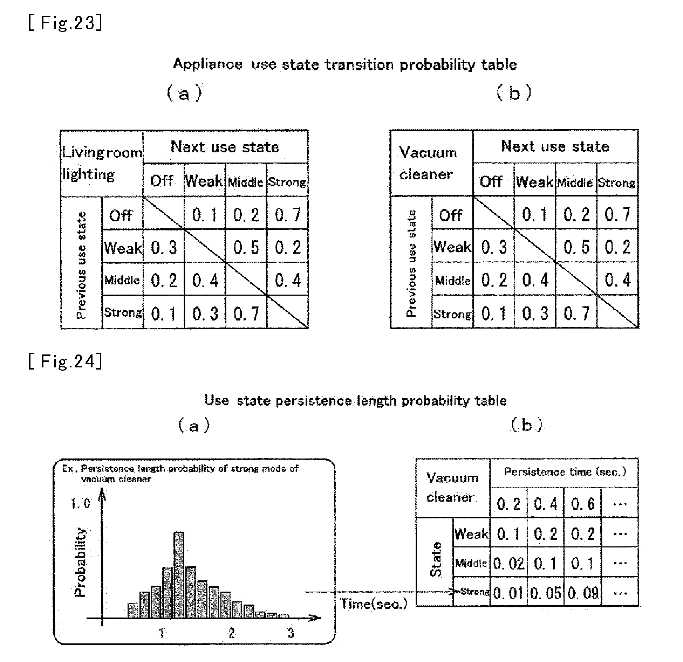

Here, the appliance use state transition probability table 12e will be described with reference to Figs. 23(a) and 23(b).

The appliance use state transition probability table 12e indicates a probability of transition of the use state of the appliance to another use state. Fig. 23(a) illustrates a state transition probability of lighting provided in the living room, and, for example, a probability of changing a previous use state "off" to the next use state "weak" is "0.1". Fig. 23(b) illustrates a state transition probability of a vacuum cleaner.

Next, the use state persistence length probability table 12f will be described with reference to Figs. 24(a) and 24(b).

The state persistence length probability table 12f indicates a time probability of persistence of the use state for each use state in each appliance. Fig. 24(a) illustrates distribution of a persistence length probability of a "strong" mode of a vacuum cleaner. Fig. 24(b) illustrates persistence length times in the "weak", "middle", and "strong" modes of the state of the vacuum cleaner.

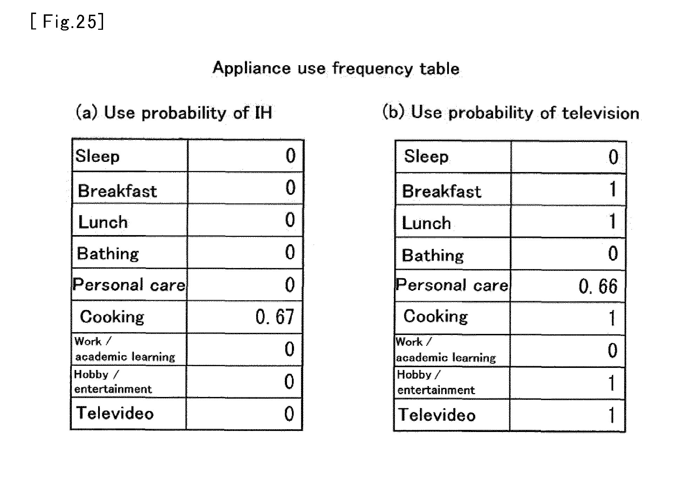

Next, the appliance use frequency table 12g will be described with reference to Figs. 25(a) and 25(b).

The appliance use frequency table 12g indicates a probability of using an appliance in each living activity. Fig. 25(a) illustrates that, while the use probability of IH indicates "0.67" only when the living activity is "cooking", the use probabilities of "television" shows that the television has a high probability of being used in "breakfast", "lunch" "hobby or entertainment", or the like.

Following that, at step S130, the next use state probability estimation unit 1k acquires a transition probability p(q''|q) of the next use state from the appliance use state transition probability table 12e, based on the type of the event, and stores the acquired information in the memory 10.

Following that, at step S135, the next use state probability estimation unit 1k acquires a transition probability p(τ|q) corresponding to the elapsed time of the occurrence of the event from the use state persistence length probability table 12f, and stores the acquired information in the memory 10.

Following that, at step S140, the next use state probability estimation unit 1k multiplies the next use state transition probability p(q''|q) and the transition probability p($\tau$|q), and calculates a product value, as probability distribution Pq'' = p(q'' |q) $\times$ p($\tau$|q) of the next use state, and stores the calculation result in the memory 10.

As a result, the probability of the appliance to be operated next can be estimated as the probability distribution Pq'' of the next use state.

Following that, at step S145, the next use state probability estimation unit 1k advances the time (t = t + 1) where q' = q, returns to step S105, and repeats the processing illustrated in steps S105 to S155.

Meanwhile, when the appliance is not currently being used, at step S150, the next use state probability estimation unit 1k acquires an appliance use frequency p(a|l) with respect to the living activity label, from the appliance use frequency table 12g, and stores the acquired information in the memory 10.

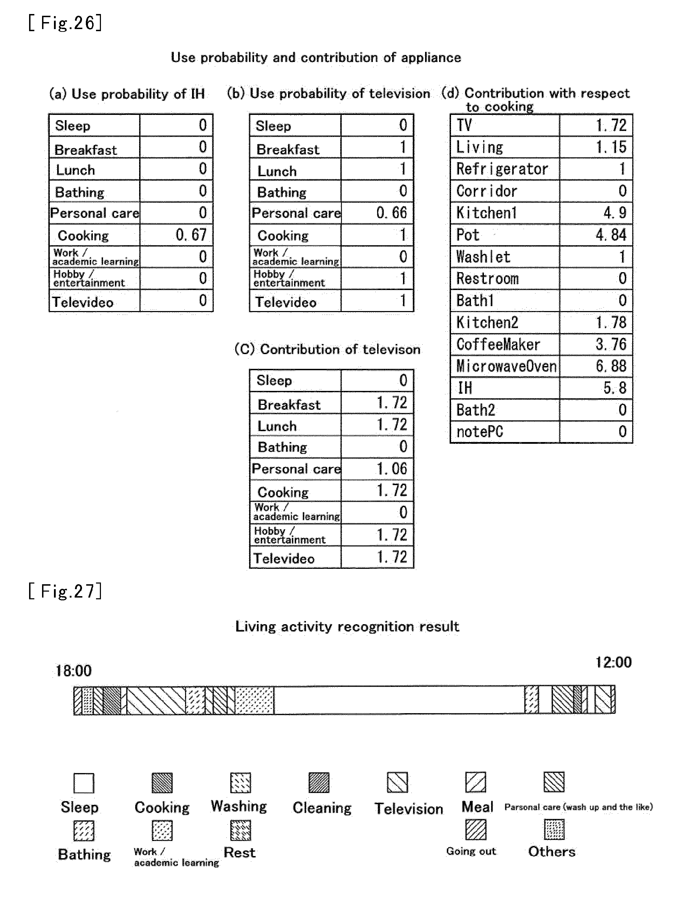

Here, the appliance use frequency table 12g illustrated in Figs. 26(a) to 26(d) will be described.

Figs. 26(a) to 26(d) are tables illustrating the use probability P and contribution C of appliances. Fig. 26(a) is a table illustrating the use probability of an IH cooker, and only the use probability in "cooking" is effective. In contrast, Fig. 26(b) is a table illustrating the use probability of the television, and the use probability is effective in "breakfast", "lunch", "personal care", and the like.

Fig. 26(c) is a table illustrating the contribution of the television, and the contribution is effective in the items such as "breakfast", "lunch", and "personal care" and the like.

Fig. 26(d) is a table illustrating the contribution with respect to the cooking, and the contribution of "kitchen", "pot", "microwave", "IH cooker" and the like are ranked high.

Following that, at step S155, the next use state probability estimation unit 1k acquires initial use state distribution p(q'|OFF) from the appliance use state transition probability table 12e of the appliance a, and stores the acquired information in the memory 10.

In the result example of the living activity estimation processing illustrated in Fig. 27, specific colors are provided and displayed corresponding to the items such as "sleep", "cooking", and "washing", in the houses (for example, from 6 p.m. to 12 p.m. of next day) of the personal living activities.

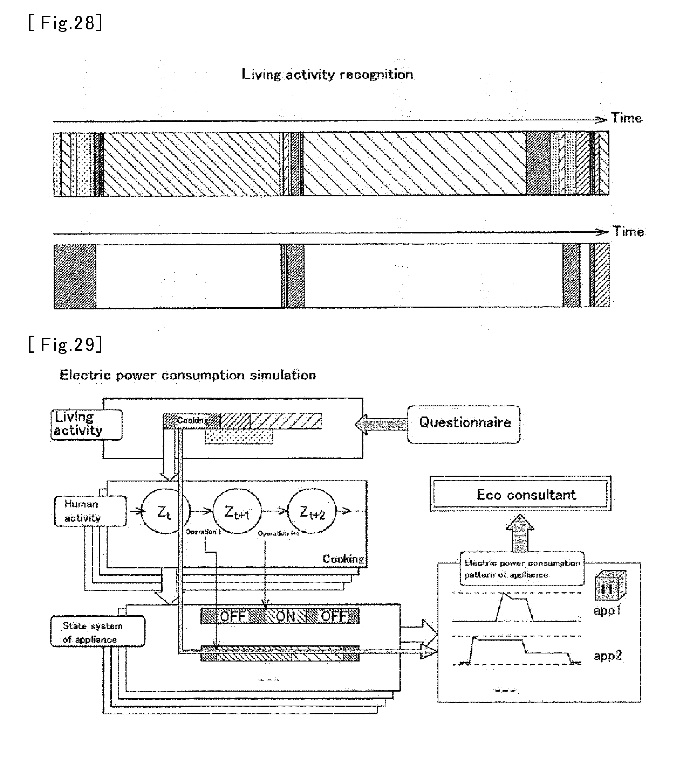

In the result example of the living activity estimation processing illustrated in Fig. 28, specific colors are provided and displayed in the hours of the personal living activities.

As described above, the transition probability of the next use state is acquired from the appliance use state transition probability table that indicates the probability of transition of a use state of an appliance, the transition probability corresponding to the elapsed time after occurrence of an event is acquired from the use state persistence length probability table that indicates the time probability of persistence of the next use state, based on the transition probability of the next use state. Following that, the probability distribution of an appliance to be operated in the next use state is calculated based on the next use state transition probability and the transition probability corresponding to the elapsed time, whereby the EoD system can be easily introduced in consideration of the personal living activities.

When the appliance is not being used, the appliance use frequency corresponding to the living activity label is acquired from the appliance use frequency table that indicates the probability of using the appliance for each living activity. Following that, the initial use state distribution is acquired from the appliance use state transition probability table that indicates the probability of transition of the use state of the appliance to another use state. Accordingly, even when the appliance is not being used, the initial use state distribution of the appliance can be acquired, whereby the EoD system can be easily introduced in consideration of the personal living activities.

<Second Embodiment>

A living activity estimation device 101 according to a second embodiment of the present invention will be described.

First, an electric power consumption simulation will be described with reference to the processing outline diagram illustrated in Fig. 29.

In the present embodiment, activity hours about basic items in a living environment, such as "sleep", "meal", and "cooking", which are to serve as labels used in processing as illustrated in Fig. 11(b), are collected from a person, using a questionnaire, and data configured from living activities (for example, cooking) and its hours is input into the living activity estimation device 101 in a table format like Excel (registered trademark).

Living activity labels at each timing, which indicate questionnaire information for estimating the living activities of a consumer in a predetermined space, are stored, and a use state of an appliance at certain point of time and a previous use state thereof are acquired from the stored details. Then, event type information that indicates the living activity in a living space is detected based on the acquired use state and previous use state of the appliance. Further, a transition probability of a next use state is acquired, and a transition probability corresponding to an elapsed time after occurrence of the event is acquired based on the transition probability of the next use state. Probability distribution of the next use state is calculated based on the next use state transition probability and the transition probability corresponding to the elapsed time, and an electric power consumption pattern that indicates an electric power value is generated according to the probability distribution of the next use state.

Finally, the electric power consumption pattern is generated. Therefore, eco-consulting can be provided to the consumer who has written in the questionnaire.

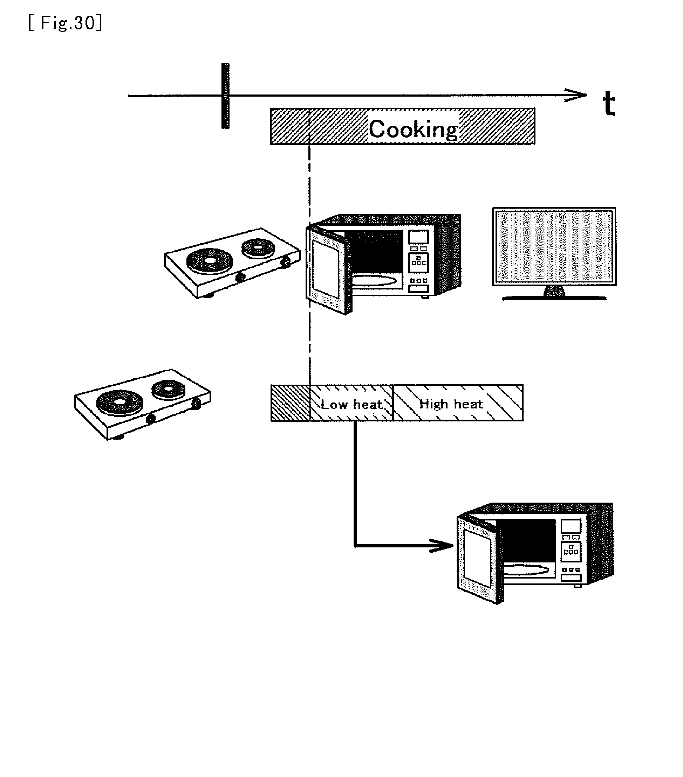

Next, an outline diagram of an appliance use model illustrated in Fig. 30 will be described.

Characteristics of how to use personal appliances with respect to the living activities will be learned.

(1) Recognize how frequently an appliance is used, a frequently used appliance is important, and strength of relationship between an appliance and a living activity.

(2) Recognize how to use an appliance, how long an appliance is used, and the order of use states.

(3) Recognize what the procedure is, the order among a plurality of appliances, and timing.

First, the appliance use model will be used. Here, (1) how frequently an appliance being used, a frequently used appliance being important, and strength of relationship between an appliance and a living activity are recognized.

A use probability P of an appliance in the appliance use model is defined as:

$$P(U_a = 1 | l) .$$

Here, Ua is defined as 1 when an appliance a is used, and defined as 0 when the appliance a is not used. How frequently the appliance a is used is expressed as the use probability P, where a living activity label is l.

Meanwhile, contribution C $(a|l_i)$ of the appliance indicates how much the appliance a is distinctive for the personal living activities, and is expressed by:

$$C(a|l_i) = P(U_a = 1 | l = l_i) / P(U_a = 1 | l \neq l_i) .$$

Next, the appliance use model, which is a living activity-appliance relationship model illustrated in Fig. 22, will be described. Here, (2) how to use an appliance, how long an appliance being used, and the order of use states are recognized.

To recognize how long, in what order, an appliance is used, a probability time automaton is suitable. In an operation pattern of an appliance in a time section where the living activity label is l, a use state transition probability P, use state persistence length distribution P, and initial use state distribution Ps are respectively expressed by:

$$P(q_j^a | l, q_i^a) ,$$

$$P(\tau_i | l, q_i^a) ,$$

and

$$P_s(q_i^a | l) .$$

Next, a personal model, which is a living activity-appliance relationship model, will be described. Here, (3) what the procedure is, the order among a plurality of appliances, and timing are recognized.

Co-occurrence characteristics between appliances are obtained from a probability of appliances being simultaneously used in a time section where the living activities are l, and a probability of one appliance being used when the other has been used.

$$P(U_{a_i}, U_{a_j} | l) / (P(U_{a_i} | l) + P(U_{a_j} | l) - P(U_{a_i}, U_{a_j} | l))$$

In timing structures between appliances, ways to use are synchronized if times of state transitions, distribution of time differences of the state transitions between the appliances, and the distribution are well organized.

$$P(T_s(q_i^a \rightarrow q_j^a) - T_s(q_{i'}^{a'} \rightarrow q_{j'}^{a'})|l)$$

Note that, in the present embodiment, description of (3) is omitted hereafter.

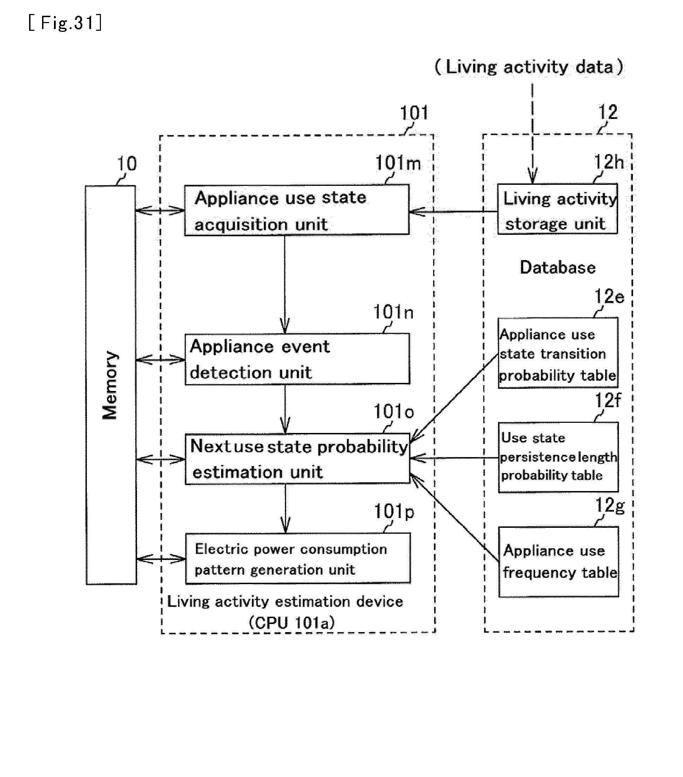

A configuration of the living activity estimation device 101 according to the second embodiment of the present invention will be described with reference to the function block diagram illustrated in Fig. 31.

The living activity estimation device 101 is configured from an appliance use state acquisition unit 101m, an appliance event detection unit 101n, a next use state probability estimation unit 101o, and an electric power consumption pattern generation unit 101p, which are made of software modules that are programs executed by a CPU 101a, and each unit performs read/write of data using a memory 10 as a work area.

The appliance use state acquisition unit 101m acquires a use state at certain timing and a previous state of an appliance from a living activity storage unit 12h that stores the living activity label at each timing, the living activity label indicating questionnaire information for estimating a living activity of a consumer in a predetermined space.

The appliance event detection unit 101n detects event type information that indicates a living activity in a living space, based on the use state and the previous use state of an appliance acquired by the appliance use state acquisition unit 101m.

The next use state probability estimation unit 101o acquires a transition probability of a next use state from an appliance use state transition probability table 12e that indicates a probability of transition of the use state of the appliance to another use state. Following that, the next state probability estimation unit 101o acquires a transition probability corresponding to an elapsed time after occurrence of an event from a use state persistence length probability table 12f that indicates a time probability of persistence of the use state, based on the transition probability of the next use state, and calculates probability distribution of the next use state, based on the next use state transition probability and the transition probability corresponding to the elapsed time.

When the appliance is not being used, the next use state probability estimation unit 101o acquires an appliance use frequency with respect to the living activity label from an appliance use frequency table 12g that indicates a probability of using the appliance in the living activity. Following that, the next state probability estimation unit 101o acquires initial use state distribution from the appliance use state transition probability table 12e that indicates a probability of transition of the use state of the appliance to another use state.

The electric power consumption pattern generation unit 101p generates an electric power consumption pattern that indicates an electric power value, according to the probability distribution of the next use state.

Further, a database 12 is configured from the living activity storage unit 12h, the appliance use state transition probability table 12e, the use state persistence length probability table 12f, and the appliance use frequency table 12g, which are stored on a hard disk HDD, for example.

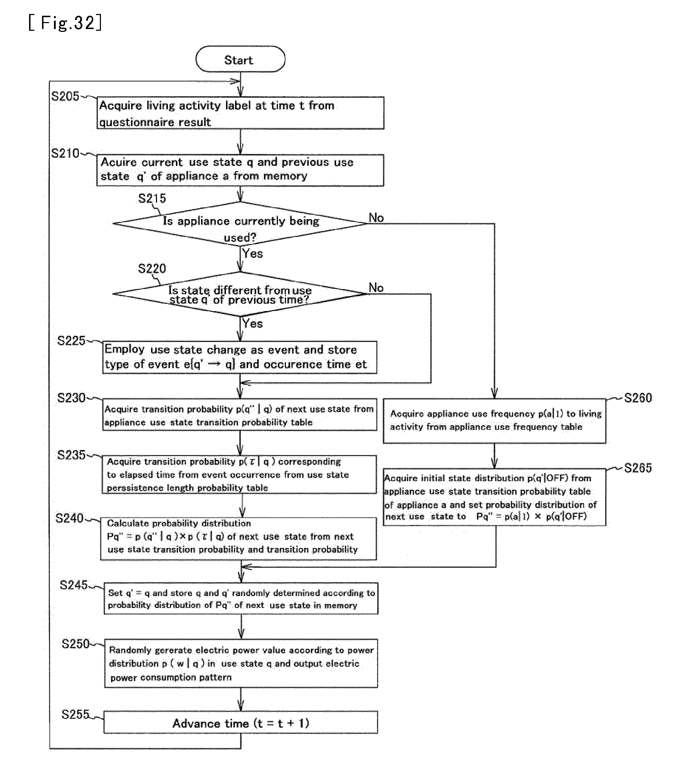

Next, an operation of the living activity estimation device 101 illustrated in Fig. 31 will be described with reference to the flowchart illustrated in Fig. 32.

First, at step S205, the appliance use state acquisition unit 101m acquires the living activity label at a time t from the living activity storage unit 12h that stores a questionnaire result, and stores the acquired information in the memory 10.

Following that, at step S210, the appliance use state acquisition unit 101m acquires a current use state q and a previous use state q' of an appliance a from the memory 10, and stores the acquires data in the memory 10.

Following that, at step S215, the appliance event detection unit 101n determines whether the appliance is currently being used. Here, when the appliance is currently being used, the appliance event detection unit 101n proceeds to step S220. When the appliance is not currently used, the appliance event detection unit 101n proceeds to step S255.

Following that, at step S220, the appliance event detection unit 101n determines whether the use state is different from the use state q' of the previous time read from the memory 10. When the use state is different from the use state q' of the previous time, the appliance event detection unit 101n proceeds to step S225. When the use state is the same as the use state q' of the previous time, the appliance event detection unit 101n proceeds to step S230.

Following that, at step S225, the appliance event detection unit 101n employs use state change as an event, and stores the type of the event e{q' → q} and an occurrence time et in the memory 10.

Following that, at step S230, the next use state probability estimation unit 101o acquires a transition probability $p(q''|q)$ of a next use state from the appliance use state transition probability table 12e, and stores the acquired information in the memory 10.

Following that, at step S235, the next use state probability estimation unit 101o acquires a transition probability $p(\tau|q)$ corresponding to an elapsed time from the event occurrence, from the use state persistence length probability table 12f, and stores the acquired information in the memory 10.

Following that, at step S240, the next use state probability estimation unit 101o calculates probability distribution Pq" = p(q"|q) × p(τ|q) of the next use state from the next use state transition probability and the transition probability, and stores the calculation result in the memory 10.

Following that, at step S260, the next use state probability estimation unit 101o acquires a appliance use frequency p(a|l) with respect to the living activity from the appliance use frequency table 12g and stores the acquired result in the memory 10.

Following that, at step S265, the next use state probability estimation unit 101o acquires initial use state distribution p(q'|OFF) from the appliance use state transition probability table 12e of the appliance a, multiplies the appliance use frequency p(a|l) and the initial use state distribution p(q'|OFF) to set a product value to probability distribution of the next use state:

$$Pq''=p(a|l) \times p(q'|OFF).$$

Following that, the next state probability estimation unit 101o proceeds to step S245.

Following that, at step S245, the electric power consumption pattern generation unit 101p causes q' = q, and stores q and q' that determines the next use state at random according to the probability distribution Pq", in the memory 10.

Following that, at step S250, the next use state probability estimation unit 101o generates an electric power value at random according to electric power distribution p(w|q) in the use state q, and generates and outputs an electric power consumption pattern.

Following that, at step S255, the electric power consumption pattern generation unit 101p advances the time (t = t + 1), returns to step S205, and repeats the processing illustrated in steps S205 to S265.

As a result, a personal electric power consumption pattern can be generated from the living activities included in the questionnaire information by the simulation.

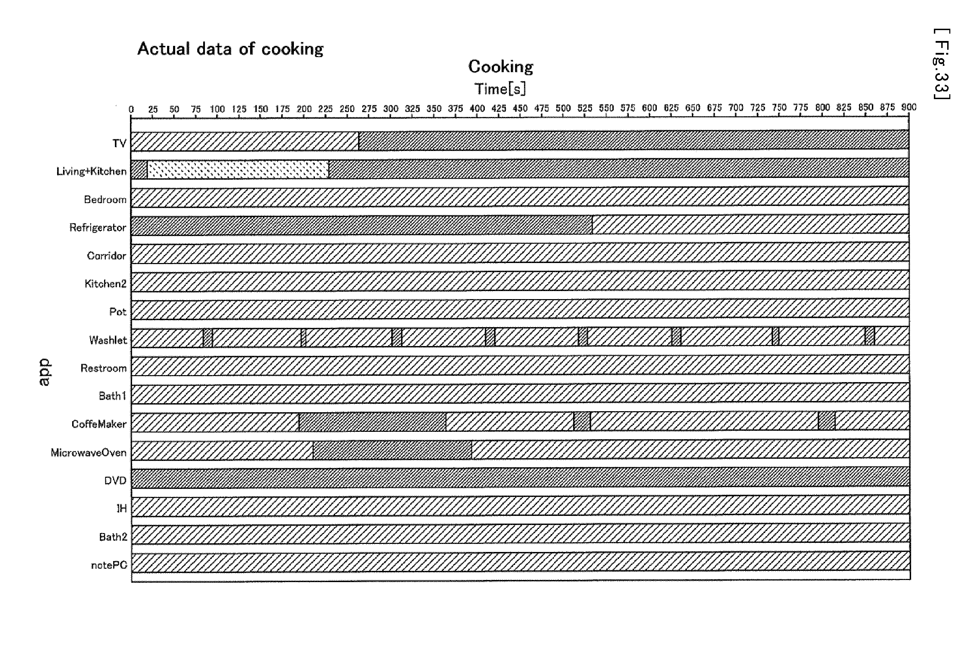

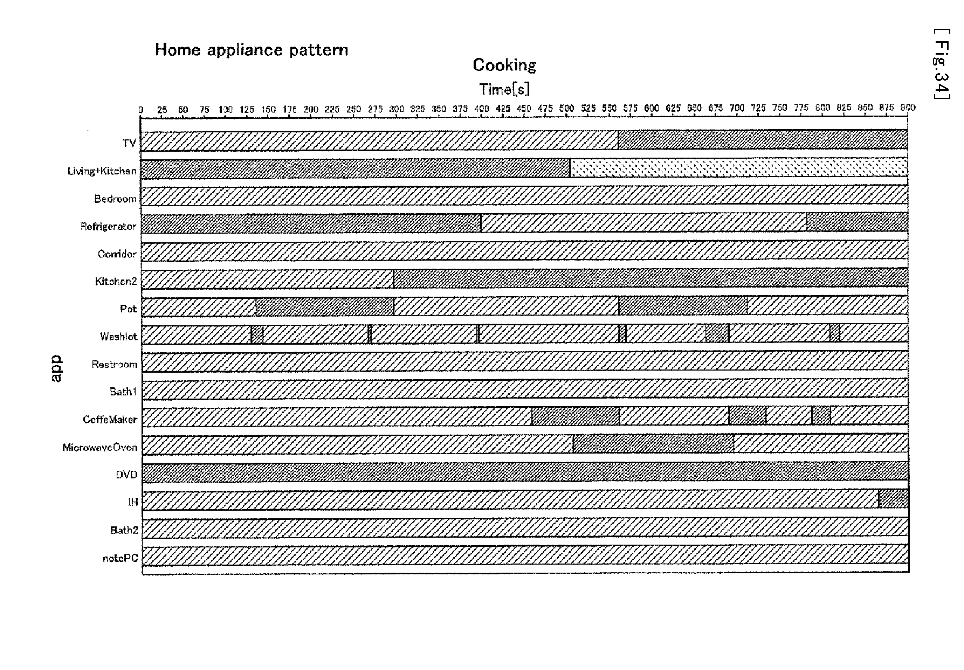

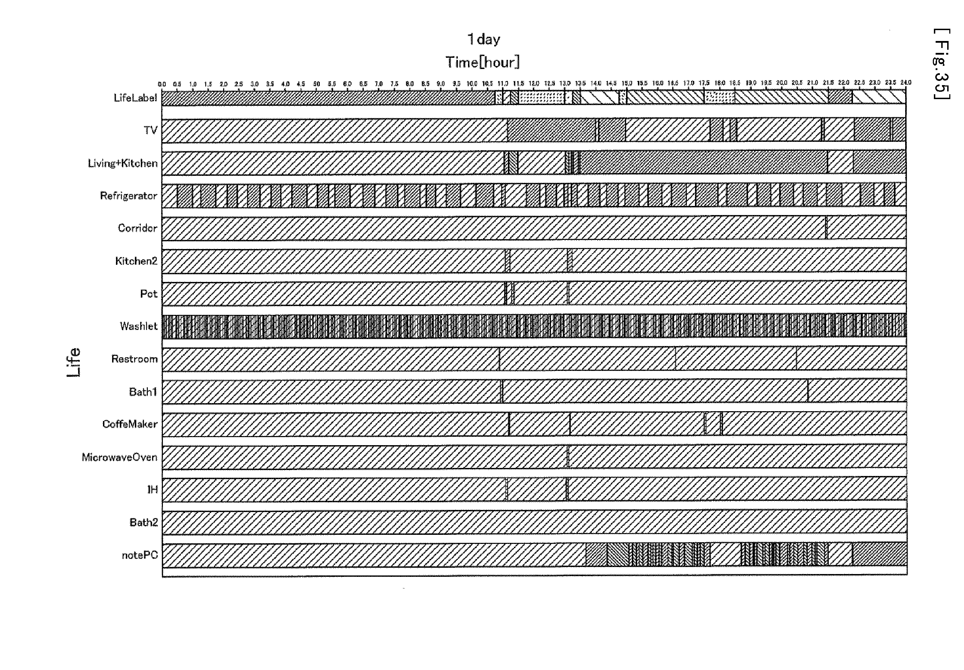

Result examples illustrated in Figs. 33, 34, 35, and 36 are described.

As described above, a living activity label at each timing, which indicates questionnaire information for estimating a living activity of a consumer in a predetermined space, is stored, and a use state and a previous use state of an appliance at predetermined timing are acquired from the stored contents. Following that, event type information that indicates a living activity in a living space is detected based on the acquired use state and previous use state of the appliance, and a transition probability of a next use state is acquired from an appliance use state transition probability table that indicates a probability of transition of the use state of the appliance to another use state. Following that, a transition probability corresponding to an elapsed time after event occurrence is acquired from a use state persistence length probability table that indicates a time probability of persistence of the use state, based on the transition probability of the next use state, and probability distribution of the next use state is calculated based on the next use state transition probability and the transition probability corresponding to the elapsed time. Following that, an electric power consumption pattern that indicates an electric power value is generated according to the probability distribution of the next use state, whereby the electric power consumption of the appliance can be verified by a simulation in advance, prior to introduction of the EoD system, and the EoD system can be easily introduced in consideration of the personal living activities.

As described above, when the appliance is not being used, the appliance use frequency with respect to the living activity label is acquired from the appliance use frequency table that indicates the probability of using the appliance in a living activity. Following that, the initial use state distribution is acquired from the appliance use state transition probability table that indicates the probability of transition of the use state of the appliance to another use state. Accordingly, even when the appliance is not being used, the initial use state distribution of the appliance can be acquired, and the electric power consumption of the appliance can be verified in advance by a simulation, prior to introduction of the EoD system, whereby the EoD system can be easily introduced in consideration of the personal living activities.

<Third Embodiment>

A living activity-electric power consumption model applicable to a living activity estimation device according to a third embodiment of the present invention will be described. Note that an electric power consumption model (LAPC model) as a generative model, which means relationship from living activities to appliance electric power consumption patterns, will be described.

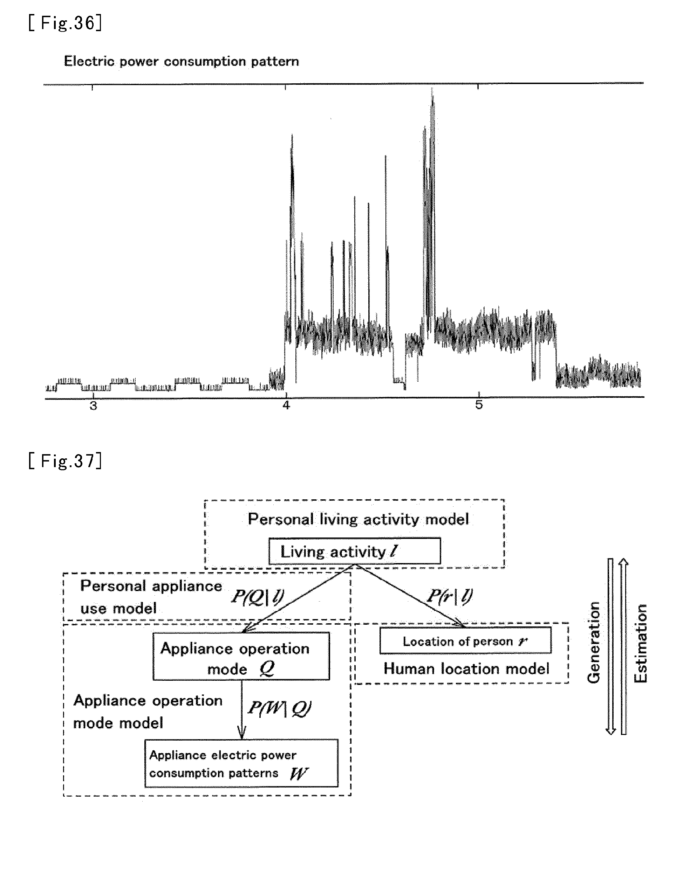

First, a structure of the LAPC model will be described with reference to the block diagram illustrated in Fig. 37.

To execute a living activity 1, after moving to a location r, a person operates and uses a set A of appliances. Q is an operation mode (use state) of each appliance in the set A of appliances. A set W of appliance electric power consumption patterns of each appliance in the set A of appliances is generated according to an operation mode Q of each appliance.

Although to be described below in details, in the LAPC model, relationship from the living activity 1 to the set W of appliance electric power consumption patterns is expressed through learning of probabilities P(Q|l), P(W|Q), and P(r|l).

This model is effective for virtually predicting and generating the set W of the appliance electric power consumption patterns of each appliance from the living activity 1. In Section 3.1 below, a method of generating the set W from the living activity 1 according to P(Q|l) and P(W|Q) available in the model will be executed.

Further, the model is similarly effective for estimating the living activity 1 from the set W of the appliance electric power consumption patterns of each appliance using Bayesian inference. In Section 3.2, a method of predicting posterior probabilities P(Q|W) and P(l|Q), based on the Bayesian inference from the learned probabilities P(Q|l) and P(W|Q), and estimating the living activity 1 from the set W of the appliance electric power consumption patterns of each appliance will be proposed. With these two methods, the LAPC model is effective for bi-directional transformation between the living activity 1 and the set W of the appliance electric power consumption patterns of each appliance.

A personal living activity is expressed by creation of a living activity model below. In Section 2.1, a personal living activity model for expressing living activities including simultaneously occurring activities will be described.

In Section 2.2, a personal appliance use model for meaning relationship between living activities and use of appliances will be described. In Section 2.3, an appliance operation mode model for expressing relationship from, an appliance operation mode to appliance electric power consumption patterns will be described. In Section 2.4, a human location model [4] for predicting that a location of the person r is based on personal operations coming in touch with appliances will be introduced.

Hereinafter, details of each sub model will be described.

<2.1 Personal Living Activity Model>

A living activity can be expressed by a label that expresses a type of an activity such as cooking, washing, or watching TV, with a duration time that indicates when the activity occurs next.

In $<l_i, b_i, e_i>$, a living activity $l_i$ is a label of $l_i$, and $b_i$ and $e_i$ indicate a start time and an end time of the living activity $l_i$.

The living activities consecutively occur in daily life. For example, a person has dinner, watches TV, takes a shower, and then sleeps. Further, a plurality of activities may occur simultaneously. For example, the person watches TV while having dinner.

That is, the living activities may be switched while overlapping with one another. Such living activities are expressed by a flat model:

$$\mathbf{I}^L = \{I_1^L, I_2^L, ..., I_Q^L\}.$$

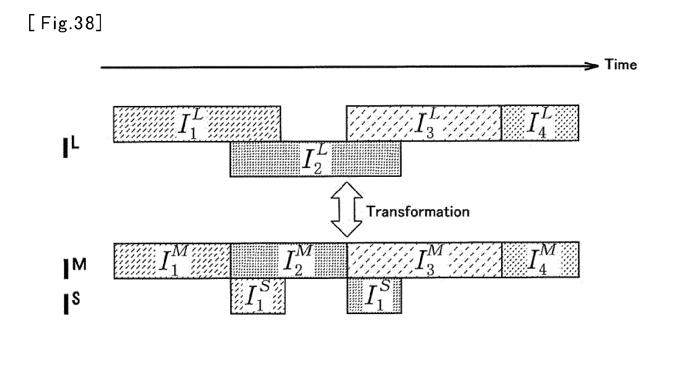

The flat model will be described with reference to the schematic diagram illustrated in Fig. 38.

In a flat model $I^L$, overlapping portions and time gaps in a plurality of activities exist, and it is difficult to estimate such a series of living activities. To solve the above problem, a main-sub activity model that is another method of expressing the living activities is introduced, which restricts the overlapping portions and time gaps, and more easily performs estimation.

In the main-sub activity model, the series of living activities is expressed using a combination of a single main activity sequence:

$$\mathbf{I}^M = \{I_1^M, I_2^M, ..., I_K^M\},$$

and
and one or more sub activity sequences:

$$\mathbf{I}^{S_j} = \{I_1^{S_j}, I_2^{S_j}, ..., I_N^{S_j}\}.$$

Here, Fig. 38 illustrates relationship between the above-described flat model and the main-sub activity model.

A main activity means an activity mainly performed depending on the location of the person to a certain extent, a constraint that no time gap exists between a certain activity and another activity is given in the main activity. Meanwhile, a sub activity indicates an activity simultaneously performed with the main activity, and does not depend on the location of the person.

For example, a person starts "washing" at a place where a washing machine exists, in the main activity. Following that, the person moves to a kitchen, and performs the main activity of "cooking" while "washing" is ongoing. At that time, "washing" is the sub activity with respect to "cooking" (kitchen) that is the main activity.

Since the sub activity does not continuously happen, there is a possibility that the time gap is within $I^{Sj}$.

As illustrated in Fig. 38, the flat model $I^L$, and $I^M$ and $I^{Sj}$ of the main-sub activity model can be easily transformed to each other. In the present embodiment, to estimate the living activities, the sub activity simultaneously occurring with the main activity is restricted up to one. However, this restriction can be easily extended to a plurality of sub activity sequences. A person always consecutively performs some activities one after another in a certain order at home. For example, the person usually eats food after cooking, and dries his/her hair after taking a shower. Also, the person usually simultaneously does some activities, such as watching TV while eating foods, as personal sub activities.

On the other hand, some activities rarely occur together, such as taking a shower while cooking. Therefore, to express transition and co-occurrence relationship between activities, the following two probabilities are used:

$I_{i-1} = <I_{i-1}, b_{i-1}, e_{i-1}>$ and $I_i = <I_i, b_i, e_i>$ are indicated as two consecutive activities. In this case, $P(I_i = I_f | I_{i-1} = I_g)$ is a transition probability from an activity $I_g$ to an activity $I_f$.

When $I_i = <I_i, b_i, e_i>$ occurs, $[b_i, e_i]$ is a time duration time. In this case, $P(I_i = I_g, I_j = I_f | [b_i, e_i] \cap [b_j, e_j] \neq 0)$ is a co-occurrence probability between the activity $I_g$ and the activity $I_f$.

The duration time of the series of activity is also an important property. To express the property, distribution $P(\tau_i | I_i = I_g)$ ($\tau_i = e_i - b_i$ of the activity of $I_g$) of the duration time is defined.

<2.2 Personal Appliance Use Model>

Typically, an appliance $a_c$ has various operation modes

$$q_1^c, q_2^c, ..., q_M^c .$$

Here, as a personal appliance use model, a probability of using an appliance $a_c$ in a living activity $I_g$:

$$P(a_c | I_g) = P(q_{on}^c | I_g)$$

is defined. Here, $q_{on}^c$

represents an operation mode of a home appliance in use.

Since appliances used in respective activities vary depending each person, $P(a_c | I_g)$ is acquired for each person through learning.

Here, a method of learning $P(a_c | I_g)$ will be discussed.

$P(a_c | I_g)$ is used in a method of estimating a living activity, which will be presented in Section 3.2 below. An appliance works with transition from one operation mode to another operation mode. The transition occurs by a personal manual operation or automatic control of the appliance.

In the present embodiment, relationship between a living activities and an operation mode of an appliance is stochastically expressed.

As described in Section 3.1 below, the appliance generates electric power consumption according to each operation mode. Further, assume that, during an activity $I_k$ is continued, the appliance $a_c$ is changed from an operation mode: $q_h^c$

to another operation mode: $q_j^c$

according to the following probability:

$$P(q_i^c = q_j^c | I_j = I_k, q_{i-1}^c = q_h^c) .$$

This can be calculated by counting the number of times of transition of the operation mode of the home appliance in the

living activity $l_k$ from: $q_h^c$

to: $q_j^c$

and dividing the counted number of times of transition by the number of times of: $q_h^c$ .

$$P(\tau_i^c|l_j = l_k, q_i^c = q_h^c)$$

This expresses distribution of the duration time of: $q_h^c$

of the appliance $a_c$ in the activity $l_k$. The distribution is expressed by a histogram that indicates proportions of the duration time in a state of being sectioned into respective lengths of the duration time. Further, the histogram can be expressed as a distribution function (for example, as a normal distribution function).

$$P(q_{k,m=1}^c = q_i^c|l_j = l_k);$$

Distribution of an initial state: $q_{k,m=1}^c$

($a_c$ of : $q_{k,m=1}^c$

in the activity $l_k$) is calculated by dividing the number of activities of $l_k$ having the initial state of: $q_i^c$

by a total number of the activity $l_k$.

When sufficient learning data is provided in advance to a specific person, $P(a_c|l_g)$ is acquired through learning of each person. However, it is difficult to sufficiently perform the learning of each person in advance. For the situation, $P(a_c|l_g)$ can be determined based on a function of an appliance instead of the learning of each person. Assume that the appliance $a_c$ is $P_f(l_g|a_c)$ that indicates the probability of being able to be used in the activity $l_g$ that accords with the function.

$P_f(l_g|a_c)$ is manually determined according to the function that the appliance has in advance. In that case, $P(a_c|l_g)$ is calculated using the following formula (1):

$$P(a_c|l_g) = \frac{P_f(l_g|a_c)P(a_c)}{P(l_g)} \qquad (1)$$

$P(a_c|l_g) = C \cdot P_f(l_g|a_c)$ is acquired by having $P(a_c)$ and $P(l_g)$ as uniform distribution, where C is a normalization constant to realize:

$$\int P(a_c | l_g)\, d a_c = 1 \ .$$

When learning of data of a way to use a home appliance of each person is effective, the data is learned using the formula (2). Here, $P(a_c|l_g)$ of each person can be learned as follows:

$$P(a_c|l_g) = (1 - \lambda(c)) \cdot P(l_g|a_c) + \lambda(c) \cdot f(c, g) \qquad (2)$$

$$\lambda(c) = log\frac{|\mathbf{I}^L|}{|\{I_i^L : a_c \ is \ used \ in \ I_i^L\}|}/log|\mathbf{I}^L|$$

where the total number of activities is $l_g$, a rate of performing the activity of the label $l_g$ using the appliance $a_c$ is f(c, g).

Here,

$$\mathbf{I}^L = \{I_i^L, i \in Z_{>0}\}$$

is a set of living activities existing in the learned data.

Basically, if the appliance $a_c$ is frequently used in the living activity $l_g$, it is assumed that $P(a_c|l_g)$ is high. That is, $P(a_c|l_g)$ can be defined with f (c, g). Note that some appliances that are used in most of the living activities (for example, "air conditioner", "fan", and others) do not contribute to determination of a living activity.

Meanwhile, appliances that are used only in specific living activities and are not used in other activities (for example, "IH cooker" used in "cooking") can contribute to determination of a living activity. Therefore, a weight coefficient $0 < \lambda(c) \leq 1$, which indicates how much the home appliance contributes to determination of a living activity, is provided to f(c, g). A small value is set to the weight coefficient when $a_c$ is used in many living activities, and a large value is set when $a_c$ is used only in specific living activities.

Further, a function of the appliance may be useful for some types of living activities, and is expressed by $P(l_g|a_c)$. Finally, as expressed by the formula (2), $P(a_c|l_g)$ is determined according to f (c, g) and $P(l_g|a_c)$. The learned $P(a_c|l_g)$ is compared with an appliance function based on $P(a_c|l_g)$ in experiments discussed in Section 4.

<2.3 Appliance Activity State Model>

A model that corresponds to an operation mode of an appliance and an electric power consumption pattern of the appliance with each other will be defined using a hybrid/dynamic system. The appliance $a_c$ (including a state of "electric power OFF") has each operation mode: $q_i^c$ ,

and the each operation mode generates electric power consumption pattern of: $w_i^c$ .

At this time, a variation pattern of the electric power consumption corresponding to the operation mode: $q_i^c$ of the appliance $a_c$ is expressed using a dynamic system of:

$$D_i^c = P(w_i^c|q_i^c)$$

of each operation mode.

In the present embodiment, assume that each dynamic system (the variation pattern of the electric power consumption) can be expressed by a normalized distribution model as described below:

$$P(w_i^c|q_i^c) \sim N(\mu_i^c, \sigma_i^c) = \frac{1}{\sqrt{2\pi}\sigma_i^c} e^{-\frac{(w_i^c-\mu_i^c)^2}{2\sigma_i^{c2}}} \qquad (3)$$

The dynamic system can be more accurately expressed using a more specific model (for example, Kalman filter). However, most of the appliances can be expressed by the normalized distribution like (3). Correspondence between the electric power consumption pattern and the operation mode of the appliance is acquired by learning of the operation mode and the dynamic system of each operation mode in advance.

<2.4 Human Location Model>

As illustrated in Fig. 37, the relationship between the living activity 1 and the appliance electric power consumption patterns W is affected by the location r of the person. As described in the opening of Section 2, the relationship P(r|l) between the living activity and the location of the person is manually allocated according to a floor plan in advance. In this section, to estimate the location r of the person from the electric power consumption patterns W of an appliance, "Human Location Model of a state space model" (the authors: Yusuke YAMADA, Takekazu KATO, and Takashi MATSUYAMA) is introduced. A basic technical concept about the model will be described below.

A person moves to a location near the appliance when using a certain appliance, and operates and use the appliance. The operation mode of the appliance is changed by such an artificial operation, and the electric power consumption pattern of the appliance is changed, accordingly. Following that, the person moves to a location near another appliance, and repeatedly operates the appliance.

As described in Section 2.3, the operation mode of the appliance $a_c$ can be estimated from the electric power consumption pattern of the appliance $a_c$, and the location of the person can be estimated according to the operated position of the operated appliance $a_c$. $r_t$ represents the location of the person at a time t. Probability distribution $P(r_t)$ of the location of the person is acquired by applying a particle filter algorithm [6] using the model. In that case, A location $r_t$ where the largest $P(r_t)$ is generated as the location of the person at the time t is determined as the location of the person.

<3. Bi-directional Transformation on LAPC Model>

In this section, a method for bi-directional transformation between personal living activities and electric power consumption patterns based on the LAPC model will be described.

<3.1 Generating Electric Power Consumption Patterns from Personal Living Activities>

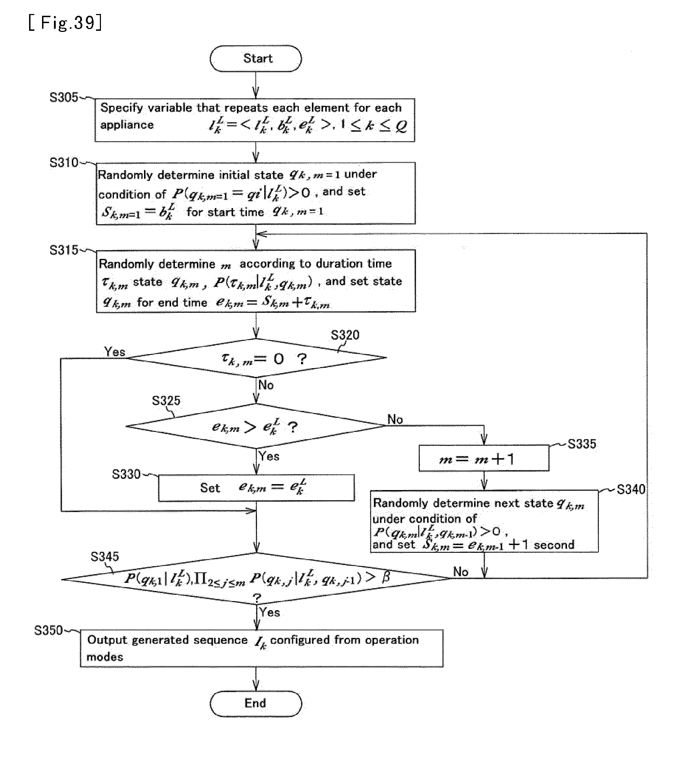

A method of generating an electric power consumption pattern in each time (second) for each appliance using the LAPC model will be described with reference to steps S305 to S350 of the flowchart illustrated in Fig. 39, assuming an activity sequence:

$$\mathbf{I}^L = \{I_1^L, I_2^L, ..., I_Q^L\}, I_k^L = <l_k^L, b_k^L, e_k^L>$$

expressed by a flat model.

First, at step S305, a variable that repeats each element is specified for each appliance (the label c of the appliance $a_c$ is removed for clarity here).

$$I_k^L = <l_k^L, b_k^L, e_k^L>, 1 \le k \le Q.$$

Following that, at step S310, $m \in Z > 0$ is set, which indicates an index of the operation mode of a in: $l_k^L$.

An initial state $q_{k, m = 1}$ is randomly determined according to a condition:

$$P(q_{k,m=1} = q_i | l_k^L) > 0,$$

and

$$s_{k,m=1} = b_k^L$$

is determined for a start time $q_{k, m = 1}$.

Following that, at step S315, m is randomly determined according to a duration time $\tau_{k, m}$ state $q_{k, m}$:

$$P(\tau_{k,m} | l_k^L, q_{k,m}),$$

and the state $q_{k, m}$ for an end time $e_{k, m} = s_{k, m} + \tau_{k, m}$ is determined.

Following that, at step S320, if it is the duration time $\tau_{k, m} = 0$, the processing proceeds to step S345.

Meanwhile, at step S325, if the end time $e_{k, m}$ is:

$$e_{k,m} > e_k^L,$$

the processing proceeds to step S330, and

$$e_{k,m} = e_k^L$$

is set and the processing proceeds to step S345.

At step S335, m = m + 1 is set.

Following that, at step S340, a next state $q_{k, m}$ is randomly determined according to a condition:

$$P(q_{k,m}|l_k^L, q_{k,m-1}) > 0,$$

and $s_{k, m} = e_{k, m-1} + 1$ second is set, and the processing proceeds to step S315.

Following that, at step S345, if it is:

$$P(q_{k,1}|l_k^L) \cdot \prod_{2 \le j \le m} P(q_{k,j}|l_k^L, q_{k,j-1}) > \beta,$$

the processing proceeds to step S350, and a generated sequence $l_k$ configured from operation modes

($q_{k,j}$, $1 \le j \le m$, for $l_k^L$) is output.

Output: I = {$l_1$, $l_2$, ..., $l_Q$}

Accordingly, the output: I = {$l_1$, $l_2$, ..., $l_Q$} can be obtained.

The above-described method randomly selects the operation mode and the duration time of the above state in order to configure the sequence $l_k$, $1 \le k \le Q$.

At step S345, a result of probability distribution of an initial operation mode, and the state transition probability of the operation mode in the sequence $l_k$ are calculated. Here, when the calculation result of the state transition probability is larger than a threshold $\beta$, the method outputs the sequence, and in other cases, the method regards the sequence inappropriate, and generates the sequence again.

A plurality of activities may occur simultaneously in $I^L$. For different activities, different operation modes of an appliance may be generated. Therefore, a plurality of different operation modes of an appliance may overlap without delay in i output in the above portion. However, only one operation mode can exist at a time for one appliance.

In the above method, the operation mode having the largest average electric power consumption at each time about each appliance in i remains. The average electric power consumption of each operation mode of each appliance is effective in the dynamic system described in Section 2.3.

Finally, the above method independently outputs the operation mode sequence independently for each appliance.

After the operation mode sequence of an appliance is acquired, the above method generates the electric power consumption pattern for the appliance using the dynamic system to be described in Section 2.3.

For each operation mode: $q_i^c$

of the appliance $a_c$ of the acquired sequence, the method more accurately acquires the electric power consumption

pattern: $w_t^c$

at each time by random sampling with respect to distribution:

$$P(w_i^c|q_i^c) \sim N(\mu_i^c, \sigma_i^c).$$

As a result, electric power consumption of each appliance is totalized, whereby the electric power consumption patterns of all family members can be used.

<3.2 Estimating Personal Living Activity State from Electric Power Consumption Pattern>

The method of estimating living activities from appliance electric power consumption patterns based on the LAPC model will be described.

<3.2.1 Estimating Appliance Operation Mode>

In estimating the living activities during a period <0, T>, first, the above method estimates the operation mode from the electric power consumption pattern during the period for each appliance.

$$\mathbf{W}_T^c = \{w_1^c, w_2^c, ..., w_T^c\}$$

is the sequence of the electric power consumption pattern: $w_t^c$

of the appliance $a_c$ of each time $0 \le t \le T$.

The method estimates an operation mode: $q_t^c$

for: $w_t^c$

at the time t by finding out an operation mode having a maximum likelihood that accords with the electric power consumption pattern from a time t - J to t + J.

J = 5 seconds is set in the experiment to be described in Section 4.

$$q_t^c = q_i^c = \arg \max_i P(q_i^c|w_{t-J}^c)...P(q_i^c|w_{t+J}^c) \qquad (4)$$

As described in Section 2.3, the dynamic system: $P(w_t^c|q_i^c)$
is effective in the LAPC model.

As described below, $P(q_i^c|w_t^c)$

is calculated based on the dynamic system that uses the Bayesian inference.

$$P(q_i^c|w_t^c) = \begin{cases} \frac{P(w_t^c|q_i^c)P(q_i^c)}{P(w_t^c)} = D \cdot P(w_t^c|q_i^c) & (1 \le t \le T) \\ 1 & (otherwise) \end{cases} \qquad (5)$$

Here, assume that $P(q_i^c)$

and $P(w_t^c)$

are uniform distribution. Also, D is a normalization constant that forms:

$$\int P(q_i^c|w_t^c)dq_i^c = 1 .$$

To acquire the duration time of each operation mode after the operation mode in each time t is acquired, a series of consecutive identical operation modes are integrated together. Finally, a series of consecutive duration times of the operation modes can be acquired.

<3.2.2 Estimating Living Activity State>

Estimation of a living activity from a sequence of an operation mode of each appliance will be described.

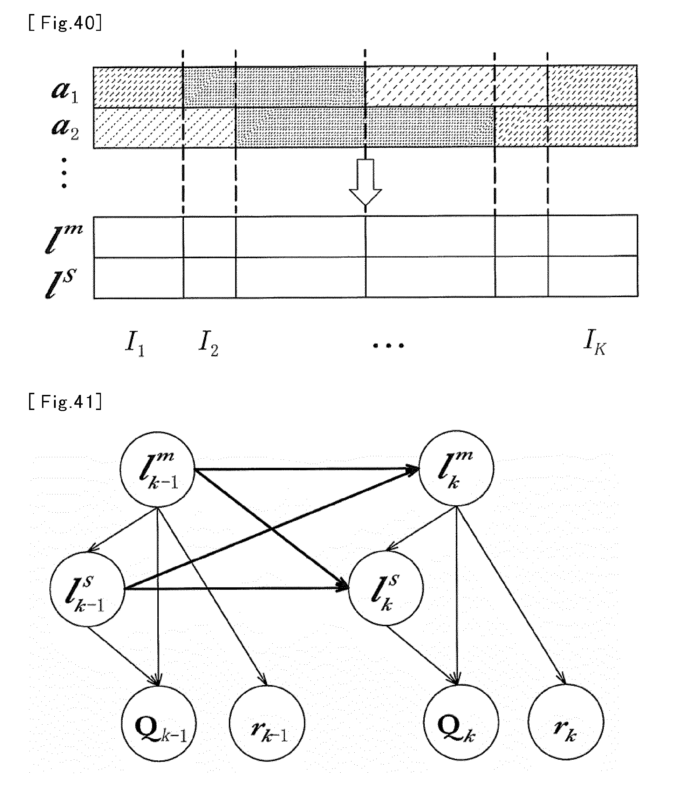

As illustrated in Fig. 40, cutting is started in the period <0, T> in several duration times $\{l_1, l_2, ..., l_K\}$, at the end time of each operation mode of each appliance.

In each duration time $l_K$, $1 \le k \le K$, only one operation mode exists for each appliance. Assume that one main activity occurs in each $l_K$. Then, Up to one sub activity may simultaneously occur with the main activity.

A set of the operation modes of each appliance in $\{a_1, a_2, ..., a_0\}$ appearing in $I_k$ is:

$$\mathbf{Q}_k = \{q_k^1, q_k^2, ..., q_k^O\} \ .$$

A room where the person stays at for the longest time during $I_k$ is $r_k$. As to be described in this section below, it is not necessary to know the precise location of the person at each time in the above method.

First, a subject to estimate personal living activities is formally defined.

Subject 1: Estimate that a combination of one main activity $l^m$ and one sub activity $l^s$ occurs suitably to each duration time $I_k$ like the following formula (6):

$$(l^m, l^s)_k = \underset{(l^m \in \mathbf{L}, l^s \in \mathbf{L} \cup L_{null})}{\arg\max} P(l^m, l^s | \mathbf{Q}_k, r_k), \qquad (6)$$

if the following items are provided as inputs:

(1) a set L of preliminarily defined candidate living activities (for example, "cooking", "cleaning", "bathing", and others),
(2) the sequences of the duration time $\{I_1, I_2, ..., I_K\}$,
(3) the set of

$$\mathbf{Q}_k = q_k^1, q_k^2, ..., q_k^O$$

of the operation modes of each appliance, and the location $r_k$ of the person during each duration time $I_k$, $1 \le k \le K$.

Here, $L_{null}$ represents that no living activity occurs. To estimate the formula (6), a rule as follows:

$$P(l^m, l^s | \mathbf{Q}_k, r_k) = \frac{P(\mathbf{Q}_k, r_k | l^m, l^s) P(l^m, l^s)}{P(\mathbf{Q}_k, r_k)}$$

$$= \frac{P(\mathbf{Q}_k | l^m, l^s) P(r_k | l^m) P(l^s | l^m) P(l^m)}{P(\mathbf{Q}_k, r_k)} \quad (7)$$

is treated, the rule being based on the LAPC model that uses the Bayesian inference.

Note that, as described in Section 2.1, assume that the sub activity is independent of the location of the person. $P(r_k | l^m)$ is provided in advance according to the main activity $l^m$ and the floor plan.

For example, "cooking" is executed in "kitchen", and thus P(kitchen|cooking) = 1 is allocated. $P(l^s | l^m)$ is a probability of simultaneous occurrence of the sub activity together with the given main activity, and can be manually provided according to details of each activity. For example, there is small possibility that cleaning occurs during bathing, and thus P(cleaning|bathing) = 0 is allocated.

$P(\mathbf{Q}_k, r_k)$ is a probability that $Q_k$ and $r_k$ can be observed, and is irrelevant to the main activity $l^m$ and the sub activity $l^s$. The normalization constant y that forms:

$$\int P(l^m, l^s | Q_k, r_k)\, dl^m dl^s = 1$$

and the probability $P(Q_k, r_k)$ are replaced.

$P(l^m)$ is past distribution of the main activity.
Here, assume that $P(l^m)$ is uniform distribution. Therefore, only $P((Q)_k | l^m, l^s)$ is estimated.

$P((Q)_k | l^m, l^s)$ that uses the following formula (8) is calculated by assuming that the use probabilities of each the appliances are independent of one another.

$$P((Q)_k | l^m, l^s)$$
$$= P(q_k^1 | q_k^2, ..., q_k^O, l^m, l^s) P(q_k^2 | q_k^3, ..., q_k^O, l^m, l^s)...P(q_k^O | l^m, l^s)$$
$$= \prod_{1 \le c \le O} P(q_k^c | l^m, l^s) \tag{8}$$

In the present embodiment, a method of calculating:

$$P(q_k^c | l^m, l^s)$$

for each appliance $a_c$ is examined.

When an appliance is powered off, the appliance is meaningless to any living activity.

$$q_k^c = OFF$$

is set, which indicates the appliance $a_c$ is powered off during the duration time $l_k$. In that case,

$$P(q_k^c = OFF | l^m, l^s) = 0.5 \tag{9}$$

is set.

For other operation modes of the appliance $a_c$, $P(q_k^c | l^m, l^s)$
is calculated by subtracting a probability that the appliance $a_c$ is not used even in the main activity $l_m$ and $l_f$ from 1, like the following formula:

$$P(q_k^c | l^m = l_g, l^s = l_h) = \quad 1 - (1 - P(a_c | l_g))(1 - P(a_c | l_h)) \tag{10}$$

$P(a_c | l_g)$ can be determined through learning for each person, particularly, or can be determined based on the appliance function for any person (see Section 2.2). In the formula (7), relationship between the living activities is not taken into consideration in two consecutive duration times. However, the transition probability should be similarly considered between the living activities.

Fig. 41 is a diagram illustrating dependent relationship existing between two consecutive duration times.

The living activities are estimated in $l_k$, $2 \le k \le K$ that uses the following formula (11) that is extended to the formula (7).

$$P(l_k^m, l_k^s | Q_k, r_k, l_{k-1}^m, l_{k-1}^s) =$$
$$\frac{P((Q)_k | l_k^m, l_k^s) P(r_k | l^m) P(l_k^s | l_k^m, l_{k-1}^m, l_{k-1}^s) P(l_k^m | l_{k-1}^m, l_{k-1}^s)}{P(Q_k, r_k)} \tag{11}$$

The formula (11) can be similarly calculated to the formula (7), except that it is necessary to estimate: $P(l_k^m | l_{k-1}^m, l_{k-1}^s)$.

To obtain the best result, the probability should be allocated according to the transition probabilities between the living activity lengths $l_{k-1}$ and $l_k$, and duration time distribution of each living activity.

In the present embodiment, for clarity, only two probabilities are determined between the living activities according to the transition probabilities.

It is estimated that there is a tendency that the activity after "cooking" is "meal".

<3.2.3 Outline of Estimation Technique>

Hereinafter, a method of estimating personal living activities from appliance electric power consumption patterns will be summarized.

A set L of candidate living activities is determined.

$P(r_k|l^m)$ according to a layout of a house is determined. $P(l^s|l^m)$ according to details of each activity is determined. $P(a_c|l_g)$ related to each activity $a_c$ and each living activity $l_g$ based on learning or an appliance function is determined using the model proposed in Section 2.2.

For the duration time $l_k$,

(1) $\mathbf{Q}_k = q_k^1, q_k^2, ..., q_k^O$

is acquired, which is a set of the operation modes of each appliance in $\{a_1, a_2, ..., a_O\}$ from the electric power consumption patterns of the appliances using the dynamic system proposed in Section 2.3.

(2) The location $r_k$ of the person is acquired using the human location model introduced in Section 2.4, which associates an operation of an appliance and the location of the consumer.

(3) The main activity $l^m \in L$ is estimated together with the sub activity $l^s \in L$ that uses the formula (11).

As an offline method of estimating the living activities during one period, a method of the present embodiment will be described in the above portion.

Actually, the method of the present embodiment can be used for both online and offline.

In steps (1) and (2) described in the above portion, the method of the present embodiment can directly acquire:

$$\mathbf{Q}_k = q_k^1, q_k^2, ..., q_k^O$$

and $r_k$ from the real-time electric power consumption patterns of each appliance.

Therefore, the method of the present embodiment can perform real-time estimation of the living activities.

In the configuration of the living activity estimation device 101 according to the second embodiment, the activity hours about the basic items in the living environment such as "sleep", "meal", and "cooking" are collected from a person, the basic items being to serve as the labels used in the processing as illustrated in Fig. 11(b), data configured from the living activities (for example, cooking) and the hours is input to the living activity estimation device 101 in a table format like Excel (registered trademark), and finally the electric power consumption patterns are generated in the living activity estimation device 101 illustrated in Fig. 31.

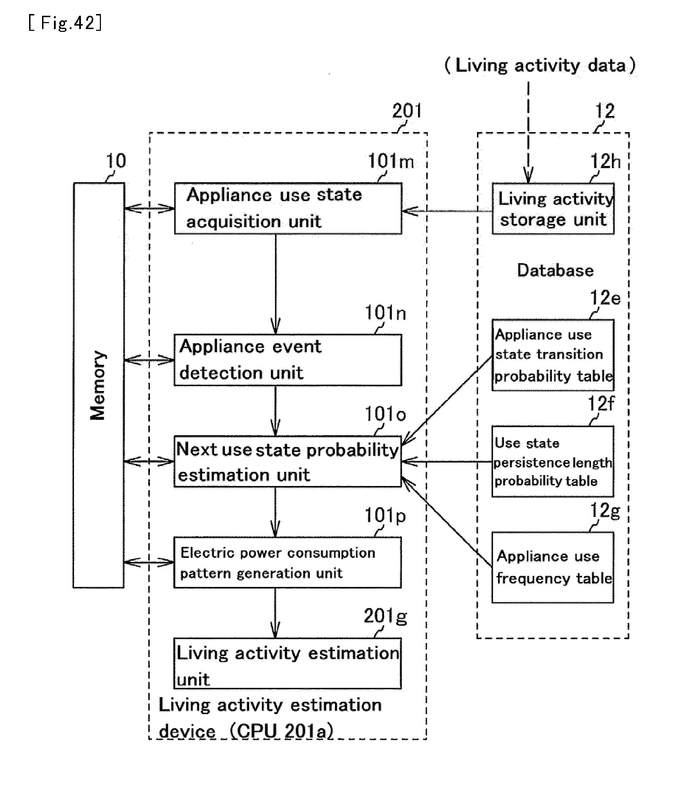

Fig. 42 is a block diagram illustrating a configuration of a living activity estimation device 201 according to the third embodiment of the present invention.

A configuration of the living activity estimation device 201 according to the third embodiment of the present invention will be described with reference to the function block diagram illustrated in Fig. 42.

The living activity estimation device 201 according to the third embodiment of the present invention is characterized to include a living activity estimation unit 201g, in addition to the living activity estimation device 101 of the second embodiment.

The living activity estimation unit 201g acquires the set of the operation modes of each appliance, based on the electric power consumption patterns generated by an electric power consumption pattern generation unit 101p, acquires the location of the consumer using the human location model that associates an operation of an appliance and the location of the consumer, and estimates the main activity depending on the location and the sub activity not depending on the location.

As described above, the personal main activity and sub activity can be estimated from the electric power consumption patterns, and the personal main activity and sub activity related to the appliance can be verified in advance by a simulation, prior to introduction of the EoD system, whereby the EoD system can be easily introduced in consideration of the personal living activities.

In the method of the present embodiment, the list of the appliances (the list of the candidate living activities and the probability $P(a_c|l_g)$ based on the appliance function) can be shared in houses having different layouts.

However, in the method of the present embodiment, acquisition of the location of the person is required similarly to the floor plan and the locations of the appliances. The location of the person is necessary to estimate the main activity. It is difficult to apply the method of the present embodiment to be put into practical use because of such a hard condition.

<4. Experiment>

In Section 4.2, first, the method of estimating the personal living activities from the appliance electric power consumption patterns will be evaluated.

As described in Section 2.4, to acquire the location of one person by the method of the present embodiment, the Human Location Model (the authors: Yusuke YAMADA, Takekazu KATO, and Takashi MATSUYAMA) can be used. In USN, vol. 111, no. 134, pp. 25-30, 2011, the above model has been confirmed through experiments in which the location of the person was able to be estimated with high precision.

In the experiments described in this section, to evaluate the method of estimating the personal living activities without interference of the model, a room where the person exists is manually pointed.

In Section 4.3, the method of generating the electric power consumption patterns from the living activities pointed through case studies will be estimated.

<4.1 Dataset and Setting>

Experiments are conducted in a smart house in which the appliances are connected to supply electric power through the smart taps.

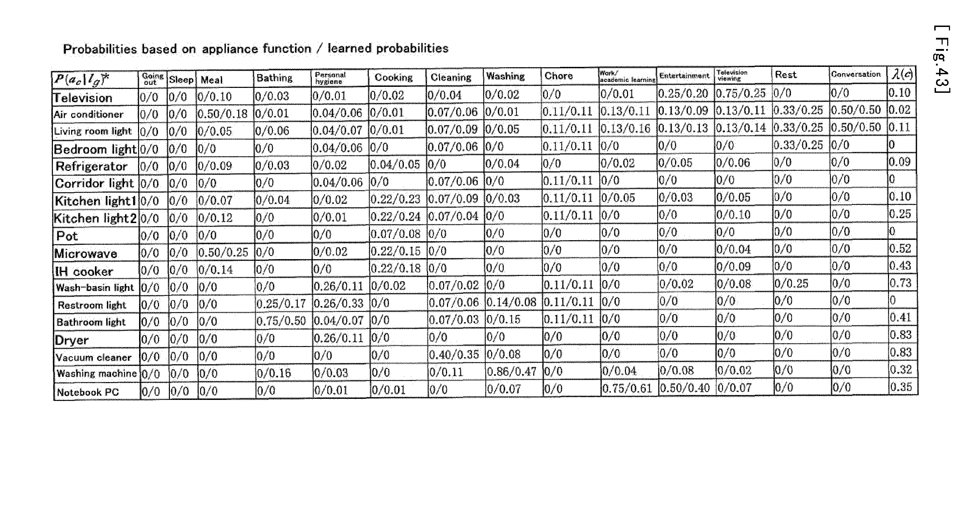

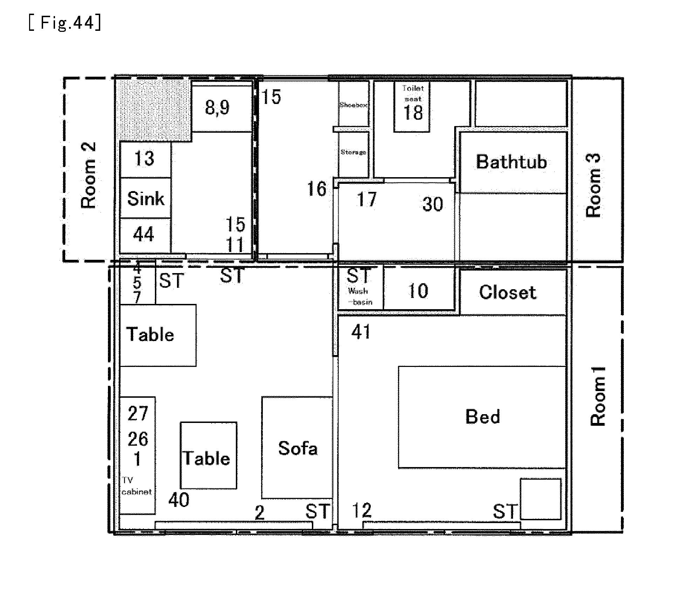

Fig. 44 is a diagram illustrating a layout of the house in which the appliances are arranged. The locations of the rooms are indicated in units of centimeters. The size of the rooms is $538 \times 605$ cm$^2$. The first row and the first column illustrated in Fig. 43 respectively indicate all of 14 labels of living activities and a part of 34 appliances as a list. In the present embodiment, a personal case where one person lives alone is considered. Three persons indicated by participants A, B, and C are asked to live in the house for 4 days, 2 days, 5 days, respectively, and asked questions. They are asked questions in order to record their living activities every 15 minutes.

<4.2 Evaluation of Living Activity Estimation>

As described in Section 3.2, the probability $P(a_c|l_g)$ that the appliance $a_c$ is used in the living activity $l_g$ can be determined by two method.

First, $P(a_c|l_g) = C \cdot P_f(l_g|a_c)$ is allocated according to the function of the appliance. A score from {0.5, 1.0, 1.5, 2.0, 2.5, 3.0} is selected for each $P_f(l_c|a_c)$.

A high score being more useful by execution of the living activity $l_g$ by the function of $a_c$ will be described. For example, apparently "television" can be used to "watch television". Therefore, $P_f$ (television|watch television) = 3.0 is allocated.

"Television" can be used for "entertainment". Therefore, $P_f$(entertainment|television) = 1.0 is allocated. Each light may be useful for "personal hygiene". Therefore, $P_f$(personal hygiene|living room light) = $P_f$(personal hygiene|betroom light) = ... = 0.5 is allocated.

The probability based on the appliance function can be applied to estimate any personal living activity.

Second, $P(a_c|l_g)$ can be learned for each participant who uses the formula (2). To evaluate data of one day of each participant, data of another day of the participant is used while the data is learned.

Fig. 43 illustrates probabilities based on the appliance function and learned probabilities for evaluating one day of the participant A.

The two kinds of probabilities are respectively normalized with $\sum_{ac \in A} P(a_c|l_g) = 1$. As defined in formula (2), the right end line indicates a $\lambda(c)$ value of each appliance.

Since the participant A left the air conditioner on for a long time, the $\lambda(c)$ value of "air conditioner" is lowest.

The $\lambda(c)$ values of "television", "living room light", and "refrigerator" are similarly low. In contrast, the $\lambda(c)$ values of "cleaner" and "dryer" are highest. The $\lambda(c)$ values accord with the consideration state in Section 2.2. Values before and after "/" in each cell are the probability based on the appliance function and the learned probability.

The learned probability is completely different from the probability based on the appliance function. For example, during a meal, the participant A left the television on. As a result, the learned P(television|taking a meal) = 0.10 is obtained. However, the appliance function is based on P(television|taking a meal) = 0. As another example, depending upon a situation, the participant A left the television, the air conditioner, the washing machine, the living room light, and the kitchen light on while bathing.

Similarly, $P(a_c|l_g)$ is further learned by other participants. It is found out that the probabilities $P(a_c|l_g)$ learned from respective participants are different. For example, during bathing, while the participant C does not leave the television on, the participants A and B leave the television on.

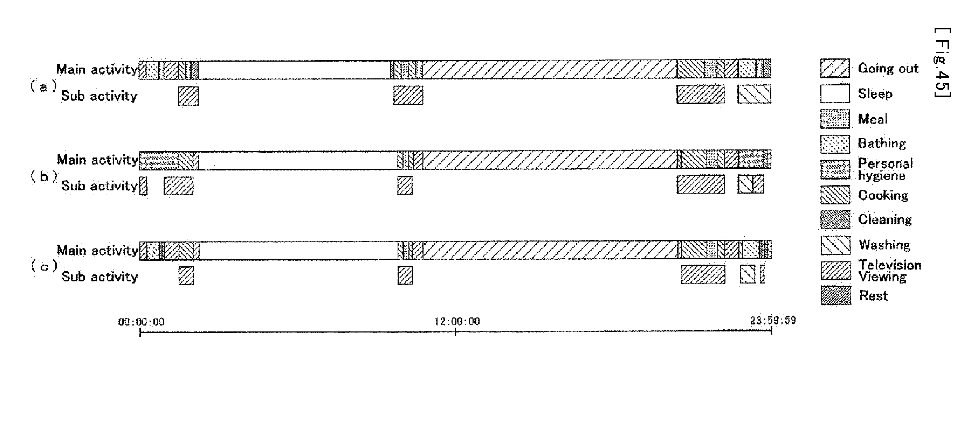

In the present embodiment, description about $P(a_c|l_g)$ learned from other participants is omitted due to space limitation. In this case, the living activities of each 4 days of the participant A who uses the method proposed in Section 3.2 are estimated using the $P(a_c|l_g)$ based on the appliance function and the learned $P(a_c|l_g)$. Similarly, the living activities of respective days of the participants B and C are estimated. For example, Figs. 45(a) and 45(b) illustrate an actual living activity sequence (a) and an estimated living activity sequence (b) of the participant A of one day from 00:00:00 to 23:59:59.

In Fig. 45(c), each color indicates a type of the living activities exemplified on the right side. At a glance, the sequence (Fig. 45(c)) estimated using the learned $P(a_c|l_g)$ is completely consistent with the actual one.

The method of the present embodiment more efficiently estimates simultaneously occurring living activities, such as the participant A watching television while cooking, or the participant A washing clothes while bathing. When the sequence estimated using the learned $P(a_c|l_g)$ and the sequence estimated using the appliance function based on $P(a_c|l_g)$ are compared, occurrence of "bathing" at around 00:30 and occurrence of "bathing" at around 23:00 cannot be estimated. The appliance function based on the probabilities of the air conditioner and the living room light in "bathing" is 0, as illustrated in Fig. 42.

The appliance function based the probabilities of these appliances in "personal hygiene" are not 0. The participant A left the appliances on during bathing.

Therefore, the method of the present embodiment using the appliance function based on the probabilities wrongly regards "personal hygiene" as "bathing". However, through the learning of the use probabilities of the appliances from the respective living activities related to the participant A, the method of the present embodiment can correctly estimate "bathing".

The method of the present embodiment will be quantitatively estimated using recall and precision.

Given the actual living activity $l_a$, a set $L_e$ of the estimated living activities appearing in the same duration time as the living activity $l_a$ is examined. The set $L_e$ includes the main activity and the sub activity. Here, the main activity is not separated from the sub activity. When there is a living activity of the same type as the living activity $l_a$ in the set $L_e$, the living activity $l_a$ is regarded to be normally estimated. In this case, the recall is calculated as a rate of activities correctly estimated in the actual living activities sequence.

On the other hand, given the estimated living activity, the set $L_a$ of the actual living activities appearing in the same time as the duration time as the living activity $l_e$ is examined. When there is a living activity of the same type as the living activity $l_e$ in the set $L_a$, the estimated activity $l_e$ is regarded correct. In that case, the precision is calculated as a rate of correct activities in the estimated living activities sequence.

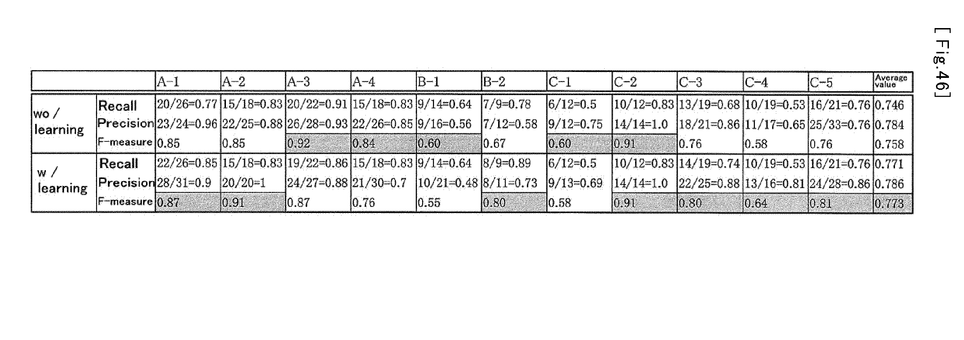

Fig. 46 is a diagram illustrating the recall, precision, and F-measure for each day of the participants A, B and C.

The values before and after "/" in each cell of "recall" are the number of the correctly estimated activities and the total number of the actual activities, respectively. The values before and after "/" in each cell of "precision" are the number of the correctly estimated activities and the total number of the estimated activities, respectively.

At first, the method of the present embodiment generates higher F-measure values using $P(a_c|l_g)$ that has learned the personal appliance use probabilities in 7 of 11 days.

The average values of the recall, precision, and F-measure with learning are 0.771, 0.786, and 0.773, and it can be said that the experimental results are excellent when the learning is performed. On the other hand, sufficient recall and precision can be obtained even when the learning is not performed.

Next, results of each day of each respective participant are examined.

The F-measure values of the respective days of the participant A are similar. The results of day 1 of the participant B are inferior because of learning. To evaluate day 1 of the participant B, day 2 is learned. Some activities occurring in day 1 of the participant B do not occur in day 2 of B. Since learning of data is insufficient, $P(a_c|l_g)$ cannot be correctly learned for the participant B. It should be taken into account that better results can be acquired for the participant B if there is more learned data. The results of day 1 of the participant C are inferior among the results of 5 days. The participant C executed "conversation" and "having a rest" in day 1. An appliance is not especially used in the two types of activities.

As a result, the method of the present embodiment does not function to detect the above two types of activities. However, the final goal of the study is to estimate the priority of the appliances in each activity.

When an appliance is not especially used in an activity, such activity can be disregarded for the final goal.

To estimate the living activities through learning the personal appliance use probability $P(a_c|l_g)$, the method of the present embodiment being effective is demonstrated. Note that it is hard to collect classified data from each user for the learning.

On the other hand, the method of the present embodiment can estimate the living activities with sufficient precision even if using the home appliance use probability $P(a_c|l_g)$ based on the function of the appliance for any users.

As a future work, an LAPC model having an appliance function based on the probability $P(a_c|l_g)$ is first configured, as a general model applicable to all users. In that case, while the living activities are estimated on the general mode, the personal appliance use probability $P(a_c|l_g)$ is learned online for each user. Eventually, the general model is updated to a personal model of each user.

<4.3 Evaluation of Generating Electric Power Consumption Pattern >

To generate the electric power consumption patterns from the living activities by the case studies, the method proposed in Section 3.1 is evaluated.

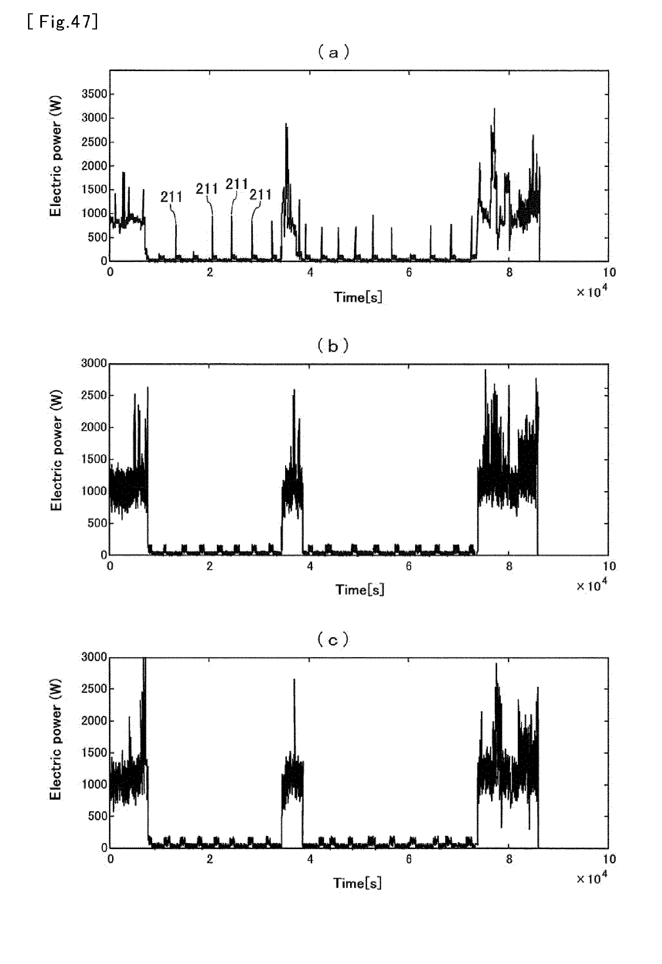

Fig. 47(a) is a diagram illustrating an actual electric power consumption pattern of day 1 of the participant A.

First, the probability distribution described in Section 2.2:

$$P(q_i^c = q_j^c | l_j = l_k, q_{i-1}^c = q_h^c), \; P(\tau_i^c | l_j = l_k, q_i^c = q_h^c)$$

and

$$P(q_{k,m=1}^c = q_i^c | l_j = l_k)$$

are learned from other three days of the participant A.

In that case, the electric power consumption patterns using the method of the present embodiment are generated from the actual living activities of the day with the learned probability distribution.

Figs. 47(b) and 47(c) illustrate two generated patterns acquired under the same experimental conditions, the generated patterns being different because the method of the present embodiment has randomness. Both of the two generated patterns are completely similar to the actual generated patterns (Fig. 47(a)). Most of the peaks in the real power consumption patterns are appropriately simulated in the generated patterns. It can be said that the method of the present embodiment configured using the LAPC model is useful for simulating appliance electric power consumption patterns from living activities.

On the other hand, the method of the present embodiment cannot generate patterns of some electric power consumption peaks.

Issues to be considered are:

(1) a point that co-occurrence or exclusiveness of appliances is not considered in the method of the present embodiment, and
(2) the electric power consumption of some appliances (for example, an air conditioner, dramatic change).

Especially, the method of the present embodiment cannot simulate peak electric power 211 occurring due to startup of a compressor provided in "refrigerator" illustrated in Fig. 47(a). These peaks occur due to activation of the compressor of the refrigerator.

The dynamic system:

$$P(D_i^c) \sim N(\mu_i^c, \sigma_i^c)$$

modeled using normalization distribution has a quite low possibility of generating this kind of peaks occurring in a very short time during an operation mode.

Reference Signs List

1... living activity estimation device, 10... memory, 11... smart tap, 12... database, 12b... appliance function model table, 12d... living activity, 12e... appliance use state transition probability table, 12f... use state persistence length probability table, 12g... appliance use frequency table, 12h... living activity storage unit, 1a... CPU, 1b... appliance use state estimation unit, 1c... event information detection unit, 1d... first weight acquisition unit, 1e... second weight acquisition unit, 1f... appliance weight multiplication unit, 1g... living activity estimation unit, 1i... appliance use state estimation unit, 1j... appliance event detection unit, 1k... next use state probability estimation unit, 20... appliance (device), 30... power control device, 32... commercial power source, 50... EoD control system, 101... living activity estimation device, 101a... CPU, 101m... appliance use state acquisition unit, 101n... appliance event detection unit, 101o... next use state probability estimation unit, 101p... electric power consumption pattern generation unit

**Claims**

1.  A living activity estimation system comprising:

at least one appliance installed in a predetermined space;
a smart tap configured to supply electric power to the appliance;
a living activity estimation device configured to estimate an event concerning the appliance, of living activities of a consumer in the space; and

a network configured to connect the appliance and the living activity estimation device through the smart tap, wherein the living activity estimation device including

appliance use state estimation means configured to estimate a use state of the appliance, based on an electric power value received from the appliance,

event information detection means configured to detect event information in the space, based on the use state of the appliance at a certain point of time and the use state of the appliance at a previous point of time of the certain point of time,

first weight acquisition means configured to acquire a first weight of each living activity by the event information, the first weight indicating relationship between change of the use state of the appliance and the living activity, from a first appliance function model table that holds the first weight, based on an elapsed time from a point of time of occurrence of the event,

second weight acquisition means configured to acquire a second weight of each living activity, the second weight indicating relationship between the use state of the appliance and the living activity, from a second appliance function model table that holds the second weight, based on the use state of the appliance,

appliance weight multiplication means configured to calculate, based on a product that is a multiplication of the first weight and the second weight, a sum of the products for each appliance, and

living activity estimation means configured to estimate a living activity in which the sum of the products of each appliance becomes a maximum value, as an actual living activity of the consumer.

2. The living activity estimation system according to claim 1, comprising:

next use state probability estimation means configured to acquire a transition probability of a next use state from an appliance use state transition probability table that indicates a probability of transition of the use state of the appliance, to acquire a transition probability corresponding to an elapsed time after occurrence of the event, from a use state persistence length probability table that indicates a time probability of persistence of the next use state, based on the transition probability of the next use state, and to calculate probability distribution of the appliance to be operated in the next use state, based on the next use state transition probability and the transition probability corresponding to the elapsed time.

3. The living activity estimation system according to claim 2, wherein, when the appliance is not being used, the next use state probability estimate means acquires an appliance use frequency with respect to a living activity label, from an appliance use frequency table that indicates a probability of using the appliance in each living activity, and acquires initial use state distribution from the appliance use state transition probability table that indicates a probability of transition of the use state of the appliance to another use state.

4. A living activity estimation device that estimates a living activity of a consumer in a predetermined space, the living activity estimation device comprising:

storage means configured to store a living activity label at each point of time, the living activity label indicating questionnaire information for estimating the living activity of a consumer in a predetermined space;

appliance use state acquisition means configured to acquire a use state at a certain point of time and a previous use state of an appliance from the storage means;

appliance event detection means configured to detect event type information that indicates the living activity in the living space, based on the use state and the previous use state of the appliance acquired by the appliance use state acquisition means;

next use state probability estimation means configured to acquire a transition probability of a next use state from an appliance use state transition probability table that indicates a probability of transition of the use state of the appliance to another use state, to acquire a transition probability corresponding to an elapsed time after occurrence of the event, from a use state persistence length probability table that indicates a time probability of persistence of the use state, based on the transition probability of the next use state, and to calculate probability distribution of the next use state, based on the next use state transition probability and the transition probability corresponding to the elapsed time; and

electric power consumption pattern generation means configured to generate an electric power consumption pattern that indicates an electric power value according to the probability distribution of the next use state.

5. The living activity estimation device according to claim 4, wherein, when the appliance is not being used, the next use state probability estimation means acquires an appliance use frequency with respect to the living activity label, from an appliance use frequency table that indicates a probability of using the appliance in the living activity, and acquires initial use state distribution from the appliance use state transition probability table that indicates a probability of transition of the use state of the appliance to another use state.

6. A living activity estimation program including at least one appliance installed in a predetermined space, a smart tap configured to supply electric power to the appliance, a living activity estimation device configured to estimate an event concerning the appliance, of living activities of a consumer in the space, and a network configured to connect the appliance and the living activity estimation device through the smart tap, and the living activity estimation program being executed by a processor provided in the living activity estimation device,
the living activity estimation device for causing the processor to execute the steps of:

appliance use state estimation step for estimating a use state of the appliance, based on an electric power value received from the appliance;
appliance event detection step for detecting event type information that indicates the living activity in the space, based on the use state of the appliance at a certain point of time and the use state of the appliance at a previous point of time of the certain point of time;
a first weight acquisition step for acquiring a first weight of each living activity by the event information, the first weight indicating relationship between change of the use state of the appliance and the living activity, from a first appliance function model table that holds the first weight, based on an elapsed time from a point of time of occurrence of the event;
a second weight acquisition step for acquiring a second weight of each living activity, the second weight indicating relationship between the use state of the appliance and the living activity, from a second appliance function model table that holds the second weight, based on the use state of the appliance;
an appliance weight multiplication step for calculating, based on a product that is a multiplication of the first weight and the second weight, a sum of the products for each appliance;
a living activity estimation step for estimating a living activity in which the sum of the products of each appliance becomes a maximum value, as an actual living activity of the consumer.

7. A computer-readable recording medium in which the program according to claim 6 is recorded.

8. A living activity estimation program executed by a processor provided in a living activity estimation device that estimates an event concerning an appliance, of living activities of a consumer in a predetermined space, the living activity estimation program causing the processor to execute the steps of:

a storage step for storing, in storage means, a living activity label at each point of time, the living activity label indicating questionnaire information for estimating the living activity of a consumer in a predetermined space,
an appliance use state acquisition step for acquiring, based on a use state of the appliance at a certain point of time and the use state of the appliance at a previous point of time of the certain point of time, the use state and the previous state in the space from the storage means;
an appliance event detection step for detecting event type information that indicates the living activity in the living space, based on the use state and the previous use state of the appliance acquired in the appliance use state acquisition step;
a next use state probability estimation step for acquiring a transition probability of a next use state from an appliance use state transition probability table that indicates a probability of transition of the use state of the appliance to another use state, acquiring a transition probability corresponding to an elapsed time after occurrence of the event from a use state persistence length probability table that indicates a time probability of persistence of the use state, based on the transition probability of the next use state, and calculating probability distribution of the next use state, based on the next use state transition probability and the transition probability corresponding to the elapsed time; and
an electric power consumption pattern generating step for generating an electric power consumption pattern that indicates an electric power value according to the probability distribution of the next use state.

9. A computer-readable recording medium in which the program according to claim 8 is recorded.

10. The living activity estimation device according to claim 4, comprising:

living activity estimation means configured to acquire a set of operation modes of each appliance, based on the electric power consumption pattern generated by the electric power consumption pattern generation means, to acquire a location of the consumer using a human location model that associates an operation of the appliance and the location of the consumer, and to estimate a main activity depending on the location and a sub activity not depending on the location.

**11.** The living activity estimation program according to claim 8, for causing the processor to execute the step of:

a living activity estimation step for acquiring a set of operation modes of each appliance, based on the electric power consumption pattern generated by the electric power consumption pattern generating step, acquiring a location of the consumer using a human location model that associates an operation of the appliance and the location of the consumer, and estimating a main activity depending on the location and a sub activity not depending on the location.

[Fig.1]

[Fig.2]

[Fig.3]

[ Fig.4]

[ Fig.5]

Layout of a home appliance

[Fig.6]

Time

[Fig.7]

Time

[Fig.8]

Life model

[Fig.9]

Electric power consumption prediction

Recognition of living activity

Prediction of appliance more likely to be used

[Fig.10]

Life is system of living activities

[Fig.11]

Living activity

(a) People's life time survey by NHK

| Sleep | Professional relationship | Care of children | Conversation/association | Television | Video/DVD |
|---|---|---|---|---|---|
| Meal | Class/school activity | Household chore | Sport | Radio | Rest |
| Personal care | Study outside school | Commute | Fun trip/stroll | Newspaper | Others |
| Cure/rest | Cooking/washing/cleaning | Commute to school | Hobby/entertainment/culture | Magazine/comic/book | Unknown |
| Work | Shopping | Social involvement | Internet | CD (compact disc)/tape | — |

(b)

| Sleep | Bathing | Child raising/ household chore |
|---|---|---|
| Meal | Parsonal care (wash up and the like) | Work/ academic learning |
| Cooking | | Cooking |
| Washing | Rest | Others |
| Cleaning | Hobby/entertainment/TV | Going out |

[Fig.12]

[ Fig.13]

Learning of living activity – home appliance relationship model (2)

[ Fig.14]

Ex)ON of television

| Hobby/ entertainment/ TV | Rest | Cooking | Meal | Cleaning | Parsonal care | Bathing | Sleep | Work/ academic learning | ... |
|---|---|---|---|---|---|---|---|---|---|
| 1 | 0.5 | 0.5 | 0.5 | 0.5 | 0.5 | 0 | 0 | 0 | |

[Fig.15]

[Fig.16]

```
                    ┌──────────────┐
                    │    Start     │
                    └──────┬───────┘
                           │
                           ▼
S5    ┌────────────────────────────────────────────────────┐
      │   Receive current electric power value from smart tap │
      └────────────────────────┬───────────────────────────┘
                               │
                               ▼
S10   ┌────────────────────────────────────────────────────┐
      │ Estimate (A) use state q of appliance from current electric power value │
      └────────────────────────┬───────────────────────────┘
                               │
             S15               ▼
                      ◇─────────────────────────◇   No
                      │ Is state different from use state q' of │────┐
                      │      previous time ?      │                  │
                      ◇─────────────────────────◇                  │
                           │ Yes                                     │
                           ▼                                         │
S20   ┌────────────────────────────────────────────────────┐        │
      │ Detect use state change as event and store type of event │   │
      │ e { q' → q } and occurrence time et               │        │
      └────────────────────────┬───────────────────────────┘        │
                               │◄─────────────────────────────────────┘
                               ▼
S25   ┌────────────────────────────────────────────────────┐
      │ Calculate weight p ( q' → q | t, l ) of living activity by event based on │
      │ appliance function model table (1) and elapsed time from event │
      │ occurrence time et                                │
      └────────────────────────┬───────────────────────────┘
                               ▼
S30   ┌────────────────────────────────────────────────────┐
      │ Acquire weight p (q | t, l) of each living activity corresponding to │
      │ current use state q from appliance function model table (2) │
      └────────────────────────┬───────────────────────────┘
                               ▼
S35   ┌────────────────────────────────────────────────────┐
      │ Calculate sum W1 = Σ p(q|l) × p(q' → q|t, l) of weight to living │
      │ activity l with respect to all appliances         │
      └────────────────────────┬───────────────────────────┘
                               ▼
S40   ┌────────────────────────────────────────────────────┐
      │ Maximum W1 to all living activities is set to living activity label of │
      │ time t  lt = arg max W1                            │
      └────────────────────────┬───────────────────────────┘
                               ▼
S45   ┌────────────────────────────────────────────────────┐
      │      Advance time (t = t + 1) where q' = q          │
      └────────────────────────────────────────────────────┘
```

[Fig.17]

Appliance function model table (1)

| Home appliance | Previous state → next state | Cooking | Washing | Entertainment | Learning | ... |
|---|---|---|---|---|---|---|
| Living room lighting | OFF → ON | 0 | 0 | 0.5 | 0.5 | ... |
| | ON → OFF | 0.5 | 0 | 0 | 0 | ... |
| Washing machine | OFF → ON | 1 | 0 | 0 | 0 | ... |
| | ON → OFF | 1 | 0 | 0 | 0 | ... |

[Fig.18]

Appliance function model table (2)

| Home appliance | Previous state → next state | Cooking | Washing | Entertainment | Learning | ... |
|---|---|---|---|---|---|---|
| Living room lighting | Bright | 0.2 | 0.2 | 0.8 | 0.8 | ... |
| | Middle | 0.5 | 0.2 | 0.8 | 0.8 | ... |
| | Dark | 0.2 | 0.2 | 0.6 | 0.6 | ... |
| Television | ON | 0.2 | 0.2 | 0.9 | 0.2 | ... |

[Fig.19]

Living activity A
Living activity B

[Fig.20]

[Fig.21]

```
                          ┌─────────┐
                          │  Start  │
                          └─────────┘
                               │
  S105 ─┌──────────────────────────────────────────────────┐
        │  Receive current power value from smart tap        │
        └──────────────────────────────────────────────────┘
                               │
  S110 ─┌──────────────────────────────────────────────────┐
        │ Estimate (A) use state q of appliance from current power value │
        └──────────────────────────────────────────────────┘
                               │
  S115                ╱ Is appliance currently ╲    No
                      ╲     being used?        ╱ ─────────────────────┐
                             │Yes                                     │
  S120              ╱ Is state different from use state ╲  No         │
                    ╲    q' of previous time?           ╱ ──────┐     │
                             │Yes                                │     │
  S125 ─┌──────────────────────────────────────────────────┐   │     │
        │ Detect use state change as event and store         │   │     │
        │ type of event e[q' → q] and occurrence time et     │   │     │
        └──────────────────────────────────────────────────┘   │     │
                             │ ◄─────────────────────────────────┘     │
  S130 ─┌──────────────────────────────────────────────────┐    ┌─────────────────────────────────┐ ─S150
        │ Acquire transition probability p(q" | q) of next use state from appliance │ │ Acquire appliance use frequency p(a|l) to │
        │ use state transition probability table in current living activity │ │ living activity from appliance use │
        └──────────────────────────────────────────────────┘    │ frequency table │
                             │                                   └─────────────────────────────────┘
  S135 ─┌──────────────────────────────────────────────────┐                    │
        │ Acquire transition probability p( τ | q) corresponding to elapsed time │  ┌─────────────────────────────────┐ ─S155
        │ from event occurence from use state persistence length probability table │ │ Acquire initial state distributin p(q' | OFF) │
        └──────────────────────────────────────────────────┘    │ from appliance use state transition │
                             │                                   │ probability table of appliance a │
  S140 ─┌──────────────────────────────────────────────────┐    └─────────────────────────────────┘
        │ Calculate probability distribution Pq" = p(q" | q) × p( τ | q) of │              │
        │ next use state from next use state transition probability and │              │
        │ transition probability │                                             │
        └──────────────────────────────────────────────────┘                    │
                             │ ◄──────────────────────────────────────────────────┘
  S145 ─┌──────────────────────────────────────────────────┐
        │       Advance time (t = t + 1) where q' = q        │
        └──────────────────────────────────────────────────┘
```

[Fig.22]

$$P(\tau \mid \text{strong}, \, 1)$$

[Fig.23]

Appliance use state transition probability table

(a)

| Living room lighting | | Next use state | | | |
|---|---|---|---|---|---|
| | | Off | Weak | Middle | Strong |
| Previous use state | Off | | 0.1 | 0.2 | 0.7 |
| | Weak | 0.3 | | 0.5 | 0.2 |
| | Middle | 0.2 | 0.4 | | 0.4 |
| | Strong | 0.1 | 0.3 | 0.7 | |

(b)

| Vacuum cleaner | | Next use state | | | |
|---|---|---|---|---|---|
| | | Off | Weak | Middle | Strong |
| Previous use state | Off | | 0.1 | 0.2 | 0.7 |
| | Weak | 0.3 | | 0.5 | 0.2 |
| | Middle | 0.2 | 0.4 | | 0.4 |
| | Strong | 0.1 | 0.3 | 0.7 | |

[Fig.24]

Use state persistence length probability table

(a)

Ex. Persistence length probability of strong mode of vacuum cleaner

1.0

Probability

Time(sec.)

1    2    3

(b)

| Vacuum cleaner | | Persistence time (sec.) | | | |
|---|---|---|---|---|---|
| | | 0.2 | 0.4 | 0.6 | ··· |
| State | Weak | 0.1 | 0.2 | 0.2 | ··· |
| | Middle | 0.02 | 0.1 | 0.1 | ··· |
| | Strong | 0.01 | 0.05 | 0.09 | ··· |

[ Fig.25]

Appliance use frequency table

(a) Use probability of IH

| Sleep | 0 |
|---|---|
| Breakfast | 0 |
| Lunch | 0 |
| Bathing | 0 |
| Personal care | 0 |
| Cooking | 0. 67 |
| Work / academic learning | 0 |
| Hobby / entertainment | 0 |
| Televideo | 0 |

(b) Use probability of television

| Sleep | 0 |
|---|---|
| Breakfast | 1 |
| Lunch | 1 |
| Bathing | 0 |
| Personal care | 0. 66 |
| Cooking | 1 |
| Work / academic learning | 0 |
| Hobby / entertainment | 1 |
| Televideo | 1 |

[Fig.26]

### Use probability and contribution of appliance

**(a) Use probability of IH**

| | |
|---|---|
| Sleep | 0 |
| Breakfast | 0 |
| Lunch | 0 |
| Bathing | 0 |
| Personal care | 0 |
| Cooking | 0.67 |
| Work / academic learning | 0 |
| Hobby / entertainment | 0 |
| Televideo | 0 |

**(b) Use probability of television**

| | |
|---|---|
| Sleep | 0 |
| Breakfast | 1 |
| Lunch | 1 |
| Bathing | 0 |
| Personal care | 0.66 |
| Cooking | 1 |
| Work / academic learning | 0 |
| Hobby / entertainment | 1 |
| Televideo | 1 |

**(d) Contribution with respect to cooking**

| | |
|---|---|
| TV | 1.72 |
| Living | 1.15 |
| Refrigerator | 1 |
| Corridor | 0 |
| Kitchen1 | 4.9 |
| Pot | 4.84 |
| Washlet | 1 |
| Restroom | 0 |
| Bath1 | 0 |
| Kitchen2 | 1.78 |
| CoffeeMaker | 3.76 |
| MicrowaveOven | 6.88 |
| IH | 5.8 |
| Bath2 | 0 |
| notePC | 0 |

**(C) Contribution of televison**

| | |
|---|---|
| Sleep | 0 |
| Breakfast | 1.72 |
| Lunch | 1.72 |
| Bathing | 0 |
| Personal care | 1.06 |
| Cooking | 1.72 |
| Work / academic learning | 0 |
| Hobby / entertainment | 1.72 |
| Televideo | 1.72 |

[Fig.27]

### Living activity recognition result

18:00          12:00

☐ Sleep   ▨ Cooking   ▨ Washing   ▨ Cleaning   ◩ Television   ▨ Meal   Parsonal care (wash up and the like)

▨ Bathing   ▨ Work / academic learning   ▨ Rest     ◪ Going out   ▨ Others

[Fig.28]

Living activity recognition

→ Time

→ Time

[Fig.29]

Electric power consumption simulation

Living activity

Cooking

Questionnaire

Human activity

$Z_t$ → $Z_{t+1}$ → $Z_{t+2}$ → - -

Operation i       Operation i+1

Cooking

Eco consultant

State system of appliance

OFF   ON   OFF

Electric power consumption pattern of appliance

app1

app2

- - -

[ Fig.30]

[Fig.31]

(Living activity data)

Living activity estimation device
(CPU 101a)

101

10

**Memory**

101m — Appliance use state acquisition unit

101n — Appliance event detection unit

101o — Next use state probability estimation unit

101p — Electric power consumption pattern generation unit

12

12h — Living activity storage unit

Database

12e — Appliance use state transition probability table

12f — Use state persistence length probability table

12g — Appliance use frequency table

[Fig.32]

```
                        ┌──────────┐
                        │  Start   │
                        └────┬─────┘
                             │
S205 ┌───────────────────────┴──────────────────────┐
     │ Acquire living activity label at time t from  │
     │ questionnaire result                          │
     └───────────────────────┬──────────────────────┘
S210 ┌───────────────────────┴──────────────────────┐
     │ Acuire current use state q and previous use   │
     │ state q' of appliance a from memory           │
     └───────────────────────┬──────────────────────┘
```

S215        Is appliance currently being used?        No ──────────────┐

Yes

S220        Is state different from use state q' of previous time?   No ──┐

Yes

S225  Employ use state change as event and store type of event e{q' → q} and occurence time et

S230  Acquire transition probability $p(q'' \mid q)$ of next use state from appliance use state transition probability table

S260  Acquire appliance use frequency $p(a \mid l)$ to living activity from appliance use frequency table

S235  Acquire transition probability $p(\tau \mid q)$ corresponding to elapsed time from event occurrence from use state perssistence length probability table

S265  Acquire initial state distribution $p(q' \mid OFF)$ from appliance use state transition probability table of appliance a and set probability distribution of next use state to $Pq'' = p(a \mid l) \times p(q' \mid OFF)$

S240  Calculate probability distribution $Pq'' = p(q'' \mid q) \times p(\tau \mid q)$ of next use state from next use state transition probability and transition probability

S245  Set q' = q and store q and q' randomly determined according to probability distribution of Pq'' of next use state in memory

S250  Randomly gererate electric power value according to power distribution $p(w \mid q)$ in use state q and output electric power consumption pattern

S255  Advance time (t = t + 1)

[Fig.33]

Actual data of cooking

Cooking Time[s]

[Fig.34]

EP 2 958 072 A1

Home appliance pattern

Cooking

Time[s]

[Fig.35]

[Fig.36]

Electric power consumption pattern

[Fig.37]

[ Fig.38]

Time

$I_1^L$  $I_2^L$  $I_3^L$  $I_4^L$

$I^L$

Transformation

$I^M$  $I_1^M$  $I_2^M$  $I_3^M$  $I_4^M$

$I^S$  $I_1^S$  $I_1^S$

[Fig.39]

```
                          ┌─────────────┐
                          │    Start    │
                          └──────┬──────┘
                                 │
S305 ┌───────────────────────────────────────────────────────┐
     │ Specify variable that repeats each element for each    │
     │ appliance   $l_k^L = <l_k^L, b_k^L, e_k^L>$, $1 \le k \le Q$ │
     └───────────────────────────┬───────────────────────────┘
                                 │
S310 ┌───────────────────────────────────────────────────────┐
     │ Randomly determine initial state $q_{k,m=1}$ under      │
     │ condition of $P(q_{k,m=1} = qi|l_k^L) > 0$, and set     │
     │ $S_{k,m=1} = b_k^L$ for start time $q_{k,m=1}$           │
     └───────────────────────────┬───────────────────────────┘
                                 │
S315 ┌───────────────────────────────────────────────────────┐
     │ Randomly determine $m$ according to duration time       │
     │ $\tau_{k,m}$ state $q_{k,m}$, $P(\tau_{k,m}|l_k^L, q_{k,m})$, and set state │
     │ $q_{k,m}$ for end time $e_{k,m} = S_{k,m} + \tau_{k,m}$  │
     └───────────────────────────┬───────────────────────────┘
                                 │
             Yes          S320  ◇ $\tau_{k,m} = 0$ ?
          ◄──────────────────────┤
                                 │ No
                                 │
          S325        ◇ $e_{k,m} > e_k^L$ ?  ───No──►
                                 │
                                 │ Yes                          S335
S330 ┌──────────────────────┐                         $m = m + 1$
     │ Set $e_{k,m} = e_k^L$ │                              │
     └──────────┬───────────┘                              │ S340
                │                    ┌──────────────────────────────┐
                │                    │ Randomly determine next state $q_{k,m}$ │
                │                    │ under condition of            │
                │                    │ $P(q_{k,m}|l_k^L, q_{k,m-1}) > 0$, │
                │                    │ and set $S_{k,m} = e_{k,m-1} + 1$ second │
                │                    └──────────────────────────────┘
                │
S345  ◇ $P(q_{k,1}|l_k^L), \prod_{2 \le j \le m} P(q_{k,j}|l_k^L, q_{k,j-1}) > \beta$ ? ──No──►
                                 │ Yes
                                 │
S350 ┌───────────────────────────────────────────────────────┐
     │ Output generated sequence $I_k$ configured from operation │
     │ modes                                                   │
     └───────────────────────────┬───────────────────────────┘
                                 │
                          ┌──────┴──────┐
                          │     End     │
                          └─────────────┘
```

[ Fig.40]

[ Fig.41]

[Fig.42]

( Living activity data )

201

12

10

**Memory**

101m

Appliance use state acquisition unit

12h

Living activity storage unit

Database

101n

Appliance event detection unit

12e

Appliance use state transition probability table

101o

Next use state probability estimation unit

12f

Use state persistence length probability table

101p

Electric power consumption pattern generation unit

12g

Appliance use frequency table

201g

Living activity estimation unit

Living activity estimation device (CPU 201a)

Probabilities based on appliance function / learned probabilities

| $P(a_c \mid l_g)^*$ | Going out | Sleep | Meal | Bathing | Personal hygiene | Cooking | Cleaning | Washing | Chore | Work/ academic learning | Entertainment | Television viewing | Rest | Conversation | $\lambda(c)$ |
|---|---|---|---|---|---|---|---|---|---|---|---|---|---|---|---|
| Television | 0/0 | 0/0 | 0/0.10 | 0/0.03 | 0/0.01 | 0/0.02 | 0/0.04 | 0/0.02 | 0/0 | 0/0.01 | 0.25/0.20 | 0.75/0.25 | 0/0 | 0/0 | 0.10 |
| Air conditioner | 0/0 | 0/0 | 0.50/0.18 | 0/0.01 | 0.04/0.06 | 0/0.01 | 0.07/0.06 | 0/0.01 | 0.11/0.11 | 0.13/0.11 | 0.13/0.09 | 0.13/0.11 | 0.33/0.25 | 0.50/0.50 | 0.02 |
| Living room light | 0/0 | 0/0 | 0/0.05 | 0/0.06 | 0.04/0.07 | 0/0.01 | 0.07/0.09 | 0/0.05 | 0.11/0.11 | 0.13/0.16 | 0.13/0.13 | 0.13/0.14 | 0.33/0.25 | 0.50/0.50 | 0.11 |
| Bedroom light | 0/0 | 0/0 | 0/0 | 0/0 | 0.04/0.06 | 0/0 | 0.07/0.06 | 0/0 | 0.11/0.11 | 0/0 | 0/0 | 0/0 | 0.33/0.25 | 0/0 | 0 |
| Refrigerator | 0/0 | 0/0 | 0/0.09 | 0/0.03 | 0/0.02 | 0.04/0.05 | 0/0 | 0/0.04 | 0/0 | 0/0.02 | 0/0.05 | 0/0.06 | 0/0 | 0/0 | 0.09 |
| Corridor light | 0/0 | 0/0 | 0/0 | 0/0 | 0.04/0.06 | 0/0 | 0.07/0.06 | 0/0 | 0.11/0.11 | 0/0 | 0/0 | 0/0 | 0/0 | 0/0 | 0 |
| Kitchen light1 | 0/0 | 0/0 | 0/0.07 | 0/0.04 | 0/0.02 | 0.22/0.23 | 0.07/0.09 | 0/0.03 | 0.11/0.11 | 0/0.05 | 0/0.03 | 0/0.05 | 0/0 | 0/0 | 0.10 |
| Kitchen light2 | 0/0 | 0/0 | 0/0.12 | 0/0 | 0/0.01 | 0.22/0.24 | 0.07/0.04 | 0/0 | 0.11/0.11 | 0/0 | 0/0 | 0/0.10 | 0/0 | 0/0 | 0.25 |
| Pot | 0/0 | 0/0 | 0/0 | 0/0 | 0/0 | 0.07/0.08 | 0/0 | 0/0 | 0/0 | 0/0 | 0/0 | 0/0 | 0/0 | 0/0 | 0 |
| Microwave | 0/0 | 0/0 | 0.50/0.25 | 0/0 | 0/0.02 | 0.22/0.15 | 0/0 | 0/0 | 0/0 | 0/0 | 0/0 | 0/0.04 | 0/0 | 0/0 | 0.52 |
| IH cooker | 0/0 | 0/0 | 0/0.14 | 0/0 | 0/0 | 0.22/0.18 | 0/0 | 0/0 | 0/0 | 0/0 | 0/0 | 0/0.09 | 0/0 | 0/0 | 0.43 |
| Wash-basin light | 0/0 | 0/0 | 0/0 | 0/0 | 0.26/0.11 | 0/0.02 | 0.07/0.02 | 0/0 | 0.11/0.11 | 0/0 | 0/0.02 | 0/0.08 | 0/0.25 | 0/0 | 0.73 |
| Restroom light | 0/0 | 0/0 | 0/0 | 0.25/0.17 | 0.26/0.33 | 0/0 | 0.07/0.06 | 0.14/0.08 | 0.11/0.11 | 0/0 | 0/0 | 0/0 | 0/0 | 0/0 | 0 |
| Bathroom light | 0/0 | 0/0 | 0/0 | 0.75/0.50 | 0.04/0.07 | 0/0 | 0.07/0.03 | 0/0.15 | 0.11/0.11 | 0/0 | 0/0 | 0/0 | 0/0 | 0/0 | 0.41 |
| Dryer | 0/0 | 0/0 | 0/0 | 0/0 | 0.26/0.11 | 0/0 | 0/0 | 0/0 | 0/0 | 0/0 | 0/0 | 0/0 | 0/0 | 0/0 | 0.83 |
| Vacuum cleaner | 0/0 | 0/0 | 0/0 | 0/0 | 0/0 | 0/0 | 0.40/0.35 | 0/0.08 | 0/0 | 0/0 | 0/0 | 0/0 | 0/0 | 0/0 | 0.83 |
| Washing machine | 0/0 | 0/0 | 0/0 | 0/0.16 | 0/0.03 | 0/0 | 0/0.11 | 0.86/0.47 | 0/0 | 0/0.04 | 0/0.08 | 0/0.02 | 0/0 | 0/0 | 0.32 |
| Notebook PC | 0/0 | 0/0 | 0/0 | 0/0 | 0/0.01 | 0/0.01 | 0/0 | 0/0.07 | 0/0 | 0.75/0.61 | 0.50/0.40 | 0/0.07 | 0/0 | 0/0 | 0.35 |

[Fig.43]

EP 2 958 072 A1

[Fig.44]

Room 2

8,9 | 15

13

Sink

44

15
11

15

Shoebox

Storage

16

17    30

Toilet seat

18

Bathtub

Room 3

4
5
7  ST    ST

Table

27
26
1

TV cabinet

40

Table

Sofa

2    ST

ST
Wash-basin    10    Closet

41

12    ST

Bed

ST

Room1

[Fig.45]

(a)
Main activity
Sub activity

(b)
Main activity
Sub activity

(c)
Main activity
Sub activity

Going out
Sleep
Meal
Bathing
Personal hygiene
Cooking
Cleaning
Washing
Television Viewing
Rest

00:00:00                    12:00:00                    23:59:59

EP 2 958 072 A1

61

[Fig.46]

EP 2 958 072 A1

|  |  | A-1 | A-2 | A-3 | A-4 | B-1 | B-2 | C-1 | C-2 | C-3 | C-4 | C-5 | Average value |
|---|---|---|---|---|---|---|---|---|---|---|---|---|---|
| wo / learning | Recall | 20/26=0.77 | 15/18=0.83 | 20/22=0.91 | 15/18=0.83 | 9/14=0.64 | 7/9=0.78 | 6/12=0.5 | 10/12=0.83 | 13/19=0.68 | 10/19=0.53 | 16/21=0.76 | 0.746 |
|  | Precision | 23/24=0.96 | 22/25=0.88 | 26/28=0.93 | 22/26=0.85 | 9/16=0.56 | 7/12=0.58 | 9/12=0.75 | 14/14=1.0 | 18/21=0.86 | 11/17=0.65 | 25/33=0.76 | 0.784 |
|  | F-measure | 0.85 | 0.85 | 0.92 | 0.84 | 0.60 | 0.67 | 0.60 | 0.91 | 0.76 | 0.58 | 0.76 | 0.758 |
| w / learning | Recall | 22/26=0.85 | 15/18=0.83 | 19/22=0.86 | 15/18=0.83 | 9/14=0.64 | 8/9=0.89 | 6/12=0.5 | 10/12=0.83 | 14/19=0.74 | 10/19=0.53 | 16/21=0.76 | 0.771 |
|  | Precision | 28/31=0.9 | 20/20=1 | 24/27=0.88 | 21/30=0.7 | 10/21=0.48 | 8/11=0.73 | 9/13=0.69 | 14/14=1.0 | 22/25=0.88 | 13/16=0.81 | 24/28=0.86 | 0.786 |
|  | F-measure | 0.87 | 0.91 | 0.87 | 0.76 | 0.55 | 0.80 | 0.58 | 0.91 | 0.80 | 0.64 | 0.81 | 0.773 |

[Fig.47]

(a)

(b)

(c)

## INTERNATIONAL SEARCH REPORT

| International application No. |
| --- |
| PCT/JP2014/053278 |

**A. CLASSIFICATION OF SUBJECT MATTER**
*G06Q50/10*(2012.01)i, *G06Q50/06*(2012.01)i

According to International Patent Classification (IPC) or to both national classification and IPC

**B. FIELDS SEARCHED**

Minimum documentation searched (classification system followed by classification symbols)
G06Q50/10, G06Q50/06

Documentation searched other than minimum documentation to the extent that such documents are included in the fields searched
Jitsuyo Shinan Koho          1922-1996   Jitsuyo Shinan Toroku Koho   1996-2014
Kokai Jitsuyo Shinan Koho    1971-2014   Toroku Jitsuyo Shinan Koho   1994-2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2012-174030 A   (Panasonic Corp.), 10 September 2012 (10.09.2012), paragraphs [0017] to [0026]; fig. 1 to 3 (Family: none) | 1-11 |
| A | JP 2005-332165 A   (Sekisui Chemical Co., Ltd.), 02 December 2005 (02.12.2005), entire text; all drawings (Family: none) | 4,5,8-11 |
| A | Yusuke YAMADA, "Human Behavior Estimation from Power Consumption Patterns of appliances over Smart Tap Network", IPSJ SIG Notes, 2011 (Heisei 23) Nendo ▲2▼ [CD-ROM], 15 August 2011 (15.08.2011) | 1-11 |

☒  Further documents are listed in the continuation of Box C.          ☐  See patent family annex.

| | |
| --- | --- |
| *    Special categories of cited documents:<br>"A"  document defining the general state of the art which is not considered    to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| 26 March, 2014 (26.03.14) | 08 April, 2014 (08.04.14) |

| Name and mailing address of the ISA/<br>   Japanese Patent Office | Authorized officer |
| --- | --- |
| Facsimile No. | Telephone No. |

Form PCT/ISA/210 (second sheet) (July 2009)

64

**INTERNATIONAL SEARCH REPORT**

International application No.

PCT/JP2014/053278

C (Continuation).  DOCUMENTS CONSIDERED TO BE RELEVANT

| Category* | Citation of document, with indication, where appropriate, of the relevant passages | Relevant to claim No. |
|---|---|---|
| A | Kenji YUASA, "Energy on Demand over SmartTap Network", IPSJ SIG Notes, 2011 (Heisei 23) Nendo ▲2▼ [CD-ROM], 15 August 2011 (15.08.2011) | 1-11 |
| A | Takekazu KATO, "Electrical Power Visualization System based on Smart Tap Network", IPSJ SIG Notes, 2011 (Heisei 23) Nendo ▲3▼ [CD-ROM], 15 October 2011 (15.10.2011), pages 1 to 6 | 1-11 |
| A | Takekazu KATO, "i-Energy Profile: Energy Informationization Profile by Smart-Tap Network", The Transactions of the Institute of Electronics, Information and Communication Engineers (J94-B), no.10, THE IEICE TRANSACTIONS ON COMMUNICATIONS (JAPANESE EDITION), 01 October 2011 (01.10.2011), vol. J94-B, pages 1232 to 1245 | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013008934 A1

**Non-patent literature cited in the description**

- **YUSUKE YAMADA ; TAKEKAZU KATO ; TAKASHI MATSUYAMA.** *USN,* 2011, vol. 111 (134), 25-30